(19) Europäisches Patentamt / European Patent Office / Office européen des brevets

(11) **EP 2 263 290 B1**

(12) **EUROPÄISCHE PATENTSCHRIFT**

(45) Veröffentlichungstag und Bekanntmachung des Hinweises auf die Patenterteilung:
**14.05.2014  Patentblatt 2014/20**

(21) Anmeldenummer: **09776407.0**

(22) Anmeldetag: **03.03.2009**

(51) Int Cl.:
*H01S 1/02* (2006.01)          *H01S 3/108* (2006.01)
*H01S 5/14* (2006.01)          *G02F 1/35* (2006.01)
*G02F 1/355* (2006.01)        *H01S 5/06* (2006.01)
*H01S 3/06* (2006.01)          *H01S 3/07* (2006.01)
*H01S 3/08* (2006.01)          *H01S 3/082* (2006.01)
*H01S 5/183* (2006.01)        *H01S 5/40* (2006.01)

(86) Internationale Anmeldenummer:
**PCT/EP2009/001500**

(87) Internationale Veröffentlichungsnummer:
**WO 2010/017851 (18.02.2010 Gazette 2010/07)**

(54) **LASERBASIERTE QUELLE FÜR TERAHERTZ- UND MILLIMETERWELLEN**

LASER-BASED TERAHERTZ AND MILLIMETER WAVE SOURCE

SOURCE LASER D'ONDES TÉRAHERTZIENNES ET MILLIMÉTRIQUES

(84) Benannte Vertragsstaaten:
**AT BE BG CH CY CZ DE DK EE ES FI FR GB GR HR HU IE IS IT LI LT LU LV MC MK MT NL NO PL PT RO SE SI SK TR**

(30) Priorität: **03.03.2008  US 67949 P**
            **30.04.2008  DE 102008021791**

(43) Veröffentlichungstag der Anmeldung:
**22.12.2010  Patentblatt 2010/51**

(73) Patentinhaber:
• **Philipps-Universität Marburg**
**35037 Marburg (DE)**
• **The Arizona Board Of Regents On Behalf Of The University of Arizona**
**Tucson, Arizona 85721-0158 (US)**

(72) Erfinder:
• **FALLAHI, Mahmoud**
**Tucson, AZ 85718 (US)**
• **MOLONEY, Jerome, V.**
**Tucson, AZ 85718 (US)**
• **KOCH, Stefan, W.**
**35112 Fronhausen (DE)**
• **KOCH, Martin**
**35274 Kirchhain (DE)**
• **BAASKE, Kai**
**38162 Cremlingen (DE)**
• **SCHELLER, Maik, Andre**
**35037 Marburg (DE)**
• **FAN, Li**
**Tucson, AZ 85712 (US)**

(74) Vertreter: **Patentanwälte Olbricht Buchhold Keulertz**
**Partnerschaft**
**Bettinastrasse 53-55**
**60325 Frankfurt (DE)**

(56) Entgegenhaltungen:
WO-A-2006/010916          WO-A-2006/102084
US-A- 5 802 086          US-A1- 2004 202 208
US-A1- 2008 043 320          US-B1- 6 388 799

• DUNN M H ET AL: "Line-narrowed, compact and coherent source of widely tunable terahertz radiation" PROCEEDINGS OF 15TH INTERNATIONAL CONFERENCE ON INFRARED AND MILLIMETER WAVES, 2007 AND THE JOINT 32ND INTERNATIONAL CONFERENCE ON TERAHERTZ ELECTRONICS, IRMMW-THZ., IEEE, 2. September 2007 (2007-09-02), Seiten 613-616, XP031249752 PISCATAWAY, NJ, USA ISBN: 978-1-4244-1438-3
• MIKHAIL A BELKIN ET AL: "Terahertz difference frequency generation in quantum cascade lasers" CLEO '07. 2007 CONFERENCE ON LASERS AND ELECTRO-OPTICS 5-11 MAY 2007 BALTIMORE, MD, USA, OSA, PISCATAWAY, NJ, USA, 1. Mai 2007 (2007-05-01), Seiten 1-2, XP031203384 ISBN: 978-1-55752-834-6

- FAN LI ET AL: "Linearly polarized dual-wavelength vertical-external-cavity surface-emitting laser" APPLIED PHYSICS LETTERS, AIP, AMERICAN INSTITUTE OF PHYSICS, MELVILLE, NY, US, Bd. 90, Nr. 18, 3. Mai 2007 (2007-05-03), Seiten 181124-181124, XP012094467 ISSN: 0003-6951
- L'HUILLIER J A ET AL: "Generation of THz radiation using bulk, periodically and aperiodically poled lithium niobate - Part 2: Experiments" APPLIED PHYSICS B ; LASERS AND OPTICS, SPRINGER, BERLIN, DE, Bd. 86, Nr. 2, 13. Dezember 2006 (2006-12-13), Seiten 197-208, XP019473385 ISSN: 1432-0649
- L'HUILLIER J A ET AL: "Generation of THz radiation using bulk, periodically and aperiodically poled lithium niobate - Part 1: Theory" APPLIED PHYSICS B ; LASERS AND OPTICS, SPRINGER, BERLIN, DE, Bd. 86, Nr. 2, 13. Dezember 2006 (2006-12-13), Seiten 185-196, XP019473381 ISSN: 1432-0649
- SASAKI YUZO ET AL: "Terahertz-wave surface-emitted difference frequency generation in slant-stripe-type periodically poled LiNbO3 crystal" APPLIED PHYSICS LETTERS, AIP, AMERICAN INSTITUTE OF PHYSICS, MELVILLE, NY, US, Bd. 81, Nr. 18, 28. Oktober 2002 (2002-10-28), Seiten 3323-3325, XP012032302 ISSN: 0003-6951

## Beschreibung

Die Erfindung betrifft ein neuartiges Verfahren und eine Vorrichtung zur Erzeugung von Terahertz- und Millimeterwellen, sowie ebenso neuartige Mittel zur Auskopplung dieser elektromagnetischen Wellen.

US 5,802,086 A offenbart eine Differenzfrequenzerzeugung innerhalb eines Laserresonators ausgehend von zwei sich kollinear ausbreitenden Laserstrahlen unterschiedlicher Wellenlänge, wobei ein nichtlinearer Kristall innerhalb des Laserresonators zur Frequenzgeneration eingesetzt wird.

In Fan Li et al: "Linearly polarized dual-wavelength vertical-external-cavity surface emittinglaser" APPLIED PHYSICS LETTERS; Bd. 90, Nr. 18, 3.Mai 2007, Seiten 181124-181124, wird die prinzipielle Eignung eines VECSEL zur Zwei-Farb-Emission demonstriert. Ferner wird dort ein aktives Medium zum Verstärken größerer Wellenlängen beschrieben.

Aus US 2008/043320 A1 ist ein V-förmiger Laserresonator bekannt, der einen nichtlinearer Kristall zur Differenzfrequenzerzeugung aufweist.

Die zentrale Idee der Erfindung ist mittels eines nichtlinearen Mediums, das innerhalb des Laserresonators eines Vertical Cavity Surface Emitting Lasers (VECSEL) oder eines anderen Lasers (wobei der andere Laser bevorzugt ein Scheibenlaser ist) positioniert ist, über Differenzfrequenzerzeugung Terahertz (THz)- oder Millimetermeterwellen zu generieren. Diese THz-Strahlung wird mittels eine geeigneten und für diesen Zweck optimierten THz-Optik geführt und extrahiert. Das Lasermedium und der Laseraufbau werden so konzipiert, dass eine möglichst hohe THz-Erzeugung und Extraktion ermöglicht wird. Das optimale VECSEL Lasermedium ist hierbei durch eine hohe Verstärkungsleistung (hoher Gewinn), große spektrale Bandbreite und geeignete spektrale Lage derart bestimmt, dass möglichst preisgünstige und/oder leistungsstarke Pumplaser oder andere Pumpquellen verwendet werden können.

Obwohl einige der verwendeten Einzelbauteile dem Fachmann bereits bekannt sind, ist insbesondere die erfindungsgemäße Kombination der Komponenten und das Verfahren zur Erzeugung von Terahertz- und Millimeter-Wellen bisher nicht bekannt. Ein Demonstrator wurde bereits aufgebaut und es wurden im Dauerstrichbetrieb bei Raumtemperatur THz-Leistungen im Bereich mehrerer Milliwatt erzielt. Die entsprechende erfindungsgemäße Vorrichtung und das Verfahren sind aber auch im Pulsbetrieb möglich. Die vorgestellten Ausführungsbeispiele lassen THz-Leistungen bis in den Watt-Bereich erwarten.

Im Folgenden wird ein Überblick über den thematischen Hintergrund zu dieser Erfindung gegeben. Gefolgt von der Beschreibung des Demonstrators und den ersten Ergebnissen. Im Anschluss daran wird der Stand der Technik in den Bereichen der einzelnen Komponenten wiedergegeben.

Während nahezu alle Bereiche des elektromagnetischen Spektrums technisch genutzt werden, ist der sogenannte Terahertz-Bereich (THz), der sich von rund 100 GHz bis rund 10 THz erstreckt, bisher kaum erschlossen.

Da THz-Wellen eine viel geringere Wellenlänge besitzen als klassische Mikrowellen, kann mit ihnen eine räumliche Auflösung erreicht werden, die unter einem Millimeter liegt. Dies macht sie interessant für viele bildgebende Anwendungen in unterschiedlichsten Bereichen. Dies schließt Sicherheitsüberprüfungen von Personen, Briefen und Gepäck ebenso ein, sowie die Vollständigkeitskontrolle von verpackten Gütern oder die Prozesskontrolle bei der Herstellung von Polymerverbundwerkstoffen. Darüber hinaus verspricht die "in-door" Kommunikation mit THz-Wellen ab ca. 2015 ein Massenmarkt zu werden.

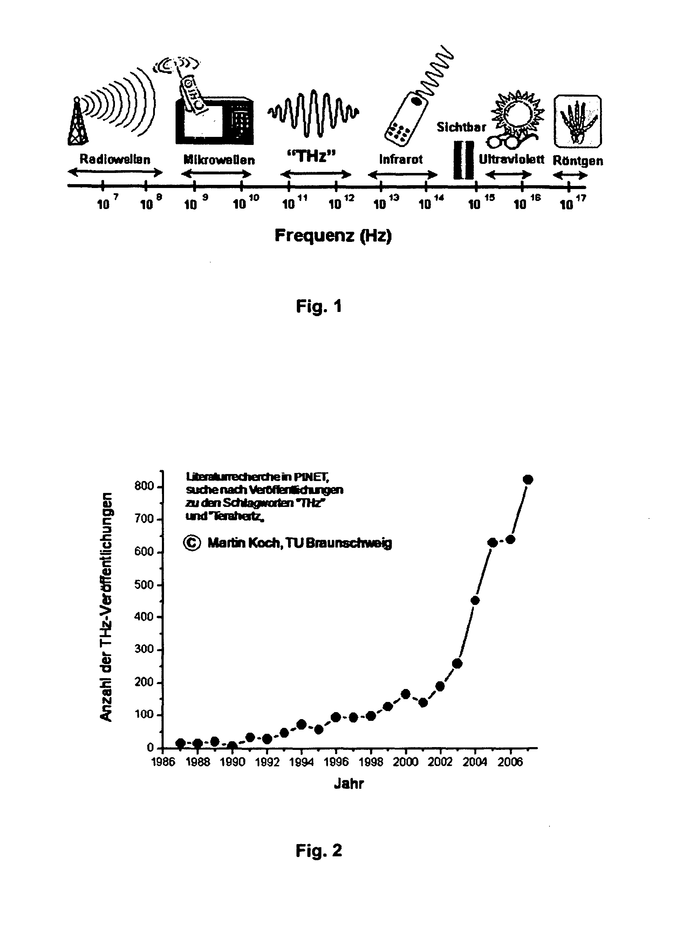

Der Terahertz-Frequenzbereich befindet sich zwischen dem der Mikrowellen und dem des infraroten Lichts. THz-Wellen können demzufolge entweder als sehr hochfrequente Mikrowellen oder als sehr langwelliges Licht (fern-infrarot Strahlung) angesehen werden. Während alle anderen Bereiche des elektromagnetischen Spektrums technologisch genutzt werden, bildet der fern-infrarote Spektralbe-reich der Terahertz-Frequenzen einen weißen Fleck auf der elektromagnetischen Landkarte (siehe Fig. 1). Grund ist der Mangel an effizienten, kostengünstigen und kompakten THz-Sendern und -Empfängern.

Es ist allerdings nicht so, dass es in der Vergangenheit unmöglich gewesen wäre, Experimente mit THz-Wellen durchzuführen. Nur waren diese mit großem experimentellem, d.h. finanziellem Aufwand verbunden und liefen meist unter dem Begriff Fern-Infrarot-Spektroskopie. Bereits Mitte des letzten Jahrhunderts wurden die THz-Eigenschaften vieler Materialien erstmals erforscht.

Unstrittig ist jedoch auch, dass es in den letzten Jahren erhebliche Fortschritte auf dem Gebiet der THz-Bauelemente gegeben hat. Als Beleg für die zunehmende Forschungsaktivität auf diesem Gebiet mag Fig. 2 gelten, welche die Anzahl der in der SPIN Datenbank zu den Schlagworten "THz" und "terahertz" gefundenen Veröffentlichungen zeigt.

## THz-Quellen im Stand der Technik

Im Folgenden werden die momentan existierenden THz-Quellen kurz dargestellt. Diese zerfallen in gepulste und Dauerstrichquellen. Jeweils angegeben ist auch die typischerweise mit diesen Quellen erzielbare Leistung und ihr derzeitiger Preis.

**Gepulste THz-Quellen**

**Photoleitende Dipolantennen**

Ein großer Schritt für die THz Technologie war das Aufkommen modengekoppelter Titan:Saphir-Laser, welche Pulse von nur wenigen zehn Femtosekunden Dauer emittieren. Seitdem wurden viele Methoden demonstriert, die aufbauend auf einem Femtosekunden-Laser THz-Pulse generieren und detektieren können. Die älteste und wahrscheinlich weit verbreitetste Methode beruht auf photoleitenden Antennen, die durch die Femtosekunden-Pulse angeregt werden. Diese Antennen bestehen aus einem Stück Galliumarsenid, auf das zwei parallele Metallstreifenleitungen aufgedampft werden. Die Laserpulse erzeugen zwischen den Leitungen Ladungsträger, die durch ein angelegtes elektrisches Feld beschleunigt werden. Die Folge ist ein kurzer Strompuls, welcher die Quelle für einen in den Raum abgestrahlten THz-Puls darstellt.

Wenn für die Anregung ein unverstärkter Titan:Saphir-Laser verwendet wird, liegt die cw-Leistung im Mikrowattbereich. Das Preisniveau wird maßgeblich durch den Femtosekundenlaser bestimmt und liegt derzeitig bei 50.000 €.

**Synchrotron, Freie-Elektronen-Laser und Smith-Purcell Emitter**

Eine weniger kompakte, auf einem Elektronenstrahl basierende Klasse von THz-Emittern umfasst Synchrotron, Freie-Elektronen-Laser, so genannte Smith-Purcell Emitter und Rückwärtswellenröhren. In einem Synchrotron und in einem Freie-Elektronen-Laser werden die Elektronen durch eine Region mit alternierenden, magnetischen Feldern geschickt, in denen sie hin und her schwingen. Diese oszillierende Elektronenbewegung führt zur Emission von THz-Strahlung. Der Smith-Purcell Emitter basiert auf einem Elektronenmikroskop, dessen Elektronenstrahl entlang der Oberfläche eines metallischen Gitters propagiert. Diese sehr teure Klasse von Quellen scheidet aufgrund ihrer beträchtlichen Größe für praktische Anwendungen aus.

**Rückwärtswellenröhren**

Rückwärtswellenröhren, auch unter Carcinotrons bekannt, besitzen etwa die Größe eines Fußballs. In diesen Elektrovakuumgeräten fliegen Elektronen über eine kammartige Struktur, die sie in periodische Bündel zusammenfasst, was zur Aussendung von THz-Strahlung führt. Obwohl es sich dabei nicht um moderne Geräte handelt, sind Rückwärtswellenröhren sehr leistungsstarke Quellen, die bei mehreren 100 GHz 10mW an monochromatischer aber durchstimmbarer THz-Leistung generieren können. Die emittierte Leistung fällt jedoch mit der Frequenz ab und der Durchstimmbereich beträgt pro ungefähr Carcinotron 100 GHz. Derzeit werden sie nur in Russland produziert und kosten etwa 25.000 € und mehr.

**P-Germanium Laser**

P-Germanium Laser nutzen Übergänge von Löchern aus dem leichten ins schwere Lochband und liefern starke THz-Pulse: Bisher arbeitet der p-Germanium Laser jedoch nur bei tiefen Temperaturen und im gepulsten Betrieb. Weiterhin benötigt er ein magnetisches Feld. Dies macht ihn ungeeignet für einen Einsatz außerhalb des Labors. Die Kosten liegen im Bereich von 200.000 €.

**Quantenkaskadenlaser**

Eine sehr vielversprechende Technologie für die Realisierung von bei Raumtemperatur arbeitenden, monolithischen, Strom betriebenen und kompakten Quellen für den Bereich von 1 - 5 THz ist der Quantenkaskandenlaser (QKL). QKL wurden erstmals 1994 von Faist und Mitarbeitern vorgestellt. Frühe QKL brauchten noch kryogene Kühlung, arbeiteten nur im gepulsten Betrieb und emittierten im mittleren Infrarotbereich. Seit den ersten Anfängen wurden beträchtliche Fortschritte gemacht. Die Entwicklung ging hin zum kontinuierlichen Betrieb, höheren Temperaturen und größeren Wellenlängen. Heutzutage arbeiten im mittleren Infrarotbereich betriebene QKL im cw-Betrieb und bei Temperaturen, die Raumtemperatur sogar übersteigen. Diese QKL sind für industrielle Anwendungen geeignet.

Bis in die späten neunziger Jahre hinein, wurde vermutet, dass man die Arbeitsfrequenz niemals unter 5 THz bringen könnte. 2002 präsentierten Tredicucci und Mitarbeiter jedoch einen QKL der bei 4,4 THz arbeitete. 2004 wurde ein QKL vorgestellt, der kontinuierliche Strahlung bei 3,2 THz bis zu einer Temperatur von 93 K emittierte. Die cw-Ausgangsleistung bei 10K betrug dabei 1,8 mW. Die Ausgangsleistung im gepulsten Betrieb liegt bei THz-QKLs immer höher, also im Bereich vieler mW. Zudem laufen gepulste THz-QKLs bei höheren Temperaturen, müssen aber immer noch gekühlt werden.

2006 demonstrierte eine andere Gruppe einen QKL für eine Frequenz von 2 THz, der einen cw-Betrieb bei 47 K erlaubte und eine maximale Leistung von 15mW bei T=4K besaß. Im Jahre 2007 erreichte eine dritte Gruppe eine cw-Leistung von 24mW bei 20 K und einer Frequenz von 2,8 THz. Infolgedessen lassen sich mit Hilfe von Stirling-Kühlern mit geschlossenem Kreislauf leichte, tragbare THz-Quellen herstellen. THz-QKLs basierte Quellen kosten zwischen 50.000 und 100.000 €.

### Dauerstrich THz-Quellen

### THz-Gaslaser

Molekulare Gaslaser, die auch als FIR Laser bezeichnet werden, beruhen auf Übergängen zwischen verschiedenen Rotationszuständen einer Molekülart. Sie können dabei bei diskreten THz Frequenzen bis zu einigen zehn mW an Leistung emittieren. Die diskreten Arbeitsfrequenzen erstrecken sich von weniger als 300 GHz bis über 10 THz. Am intensivsten ist eine Methanollinie bei 2.52 THz. Ein solcher Laser muss jedoch von einem durchstimmbaren Kohlendioxidlaser gepumpt werden, was für das gesamte System einen großen Platzbedarf bedeutet. Bedauerlicherweise sind THz-Gaslaser nicht nur sperrig sondern auch teuer (knapp 100.000 €).

### Quantenkaskadenlaser

Quantenkaskadenlaser wurden bereits unter 1.1. als gepulste THz-Quelle vorgestellt. Sie laufen auch im cw-Betrieb allerdings mit geringerer Leistung. Auch dies wurde oben bereits diskutiert.

### Auf klassischer Mikrowellentechnik basierende Emitter

THz-Emitter können mit Hilfe von Mikrowellentechnologie realisiert werden, die auf Gunn, Impatt oder resonanten Tunneldioden basieren. Da die Fundamentalfrequenzen dieser Systeme zumeist nicht hoch genug für viele THz-Anwendungen sind, müssen sie erst durch spezielle Mischer vervielfacht werden. Eine auf Mikrowellentechnologie basierende THz-Quelle findet leicht in einen Schuhkarton Platz. Sie kostet typischerweise mehrere zehn tausend Euro. Die Leistung bei Frequenzen über einem THz liegt unter 1 mW und die Quellen sind nur bedingt abstimmbar. Die Durchstimmbarkeit liegt im Bereich von wenigen 10 GHz.

### Photomischer

Ein weit verbreitetes Verfahren zur Erzeugung von THz-Strahlung basiert auf photoleitenden THz-Antennen, die optisch von zwei cw Laserdioden angeregt werden, die mit leicht unterschiedlicher Frequenz schwingen. Die Emission dieser Laser wird auf der Antenne überlagert, die bei Anregung mit cw Lasern auch Photomischer genannt wird. Die resultierende Lichtschwebung wird dabei in einen oszillierenden Antennenstrom gewandelt, der die Quelle einer monochromatischen THz-Welle ist. Die erzielten Leistungen liegen bei wenigen $\mu$W. Inklusive der Pumplaser kostet eine THz-Quelle 10.000 bis 20.000€.

### Direkte Abstrahlung von Zwei-Farben-Lasern

Kürzlich konnten Hoffmann und Mitarbeiter (Universität Bochum) zeigen, dass diese "Zwei-Farben-Laser" selbst THz-Strahlung, aufgrund eines nichtlinearen Prozesses aussenden. Allerdings war die Strahlungsleistung sehr gering und lag an der Nachweisgrenze. Der Preis liegt bei wenigen 1.000 €.

In der folgenden Tabelle werden die Daten der verfügbaren cw THz-Systeme zusammengefasst, u.a. sind die Leistung P_max in der Umgebung von 1 THz, die Durchstimmbarkeit, die Systemgröße und Kosten aufgelistet.

| Verfahren | CW | P_max (mW) | Durchstimmbar | Systemgröße | Preis (in Tsd. $) | Bemerkungen |
|---|---|---|---|---|---|---|
| Gas Laser | X | Bis zu 50 | Diskrete Linien | groß | 100 | Stärkste Linie bei 2.5 THz (50mW) andere Linien emittieren nur wenige mW |
| Mikrowellen basierend | X | < 1 | kaum | Schuhkarton | 60 | Leistung nimmt über 1 THz ab |

(fortgesetzt)

| Verfahren | CW | P_max (mW) | Durchstimmbar | Systemgröße | Preis (in Tsd. $) | Bemerkungen |
|---|---|---|---|---|---|---|
| Photomischung | X | 0.005 | ja | klein | 15 | Leistung nimmt über 1 THz ab |
| THz-QKL | X | 30 | kaum | klein | 50 | Benötigt Kühlung, die Leistung wird jährlich besser |
| Neue Quelle | X | >>10 | ja | klein | 50 | Die Leistung nimmt mit Frequenz zu |

Zusammenfassend lässt sich feststellen, dass viele verschiedene THz-Quellen existieren, jede mit ihren eigenen Vorteilen und Schwächen.

Die Nachteile bestehen meist darin, dass die Systeme sehr komplex und damit teuer sind oder/und relativ leistungsschwach (Leistung im Bereich von nur $\mu$W) oder/und nicht durchstimmbar oder/und nur im Dauerstrichbetrieb oder nur im gepulsten Betrieb betreibbar sind oder gar aufwendig gekühlt werden müssen.

Aufgabe der Erfindung ist es daher, eine Vorrichtung samt dazu notwendiger neuartiger Einzelkomponenten, sowie ein Verfahren zur Erzeugung von Terahertz- oder Millimeterwellen vorzusehen, welche/s die vorgenannten Nachteile weitestgehend vermeiden/t.

Diese Aufgaben werden bzgl. der Vorrichtung durch den Gegenstand gemäß Anspruch 7 bis 9 und bzgl. des Verfahrens durch den Gegenstand gemäß Anspruch 1 bis 6 gelöst.

Überraschenderweise wurde gefunden, dass verschiedenste nichtlineare Medien intrakavitär zum Zwecke der Terahertz- und Millimeterwellen-Erzeugung eingesetzt werden können, da sie nicht nur den einwirkenden Leistungsdichten widerstehen, sondern auch eine effiziente Frequenzdifferenzerzeugung gewährleisten. Dies gilt für Dauerstrich Betrieb und auch bei spektraler Durchstimmbarkeit der Gesamtvorrichtung!

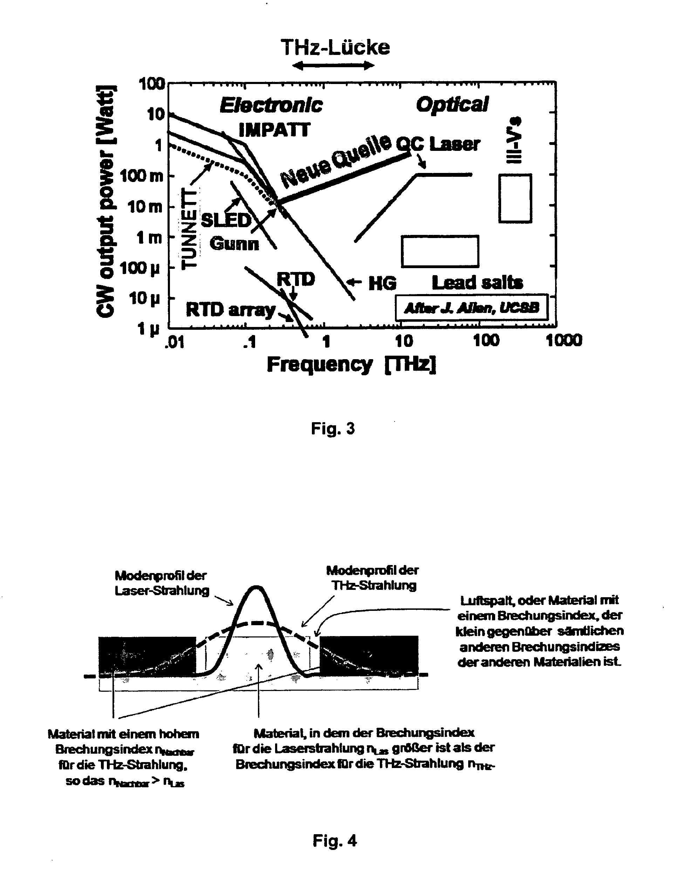

Eine Zusammenstellung der Leistungsdaten existierender THz-Quellen (siehe Fig. 3) zeigt sehr anschaulich die sogenannte THz-Lücke. Im Bereich zwischen wenigen hundert GHz und einigen THz existieren derzeit keine kompakten durchstimmbaren Quellen. Unsere nachstehend beschriebene leistungsstarke "neue THz-Quelle" kann diese Lücke schließen. Die für die neue Quelle angegebenen Leistungsdaten stellen eine konservative Schätzung dar. Bei einigen der nachgenannten Ausführungsbeispiele wird erwartet, dass die erreichbare THz-Leistung oder/und Leistung im Millimeterwellen-Bereich noch beträchtlich darüber liegen.

Die erfindungsgemäße neue Vorrichtung mit den neuartigen Betriebsverfahren, kurz die von uns vorgestellte "neue Quelle" verspricht eine Leistungsverbesserung von mehreren Größenordnungen gegenüber bereits erhältlichen Systemen

Demonstrator (Erfindung) zur intrakavitären THz-Erzeugung mittels Zwei-Wellenlängen VECSEL Resonator und nichtlinearem Kristall

Basierend auf dem erfindungsgemäßen Konzept wurden von uns neben detaillierten theoretischen Berechnungen und Abschätzungen bereits erste Demonstrationsexperimente durchgeführt, die das weitreichende Potential der vorgestellten Erfindung nachdrücklich belegen. Bereits nach zwei einfachen Optimierungsschritten konnten wir THz-Ausgangsleistungen im Dauerstrichbetrieb bei Raumtemperatur erzielen, die die der meisten bisher bekannten Quellen deutlich übertreffen. Etwas leistungsstärker sind derzeit nur THz-Gas Laser und THz-Quantumkaskadenlaser. Diese beiden Quellentypen sind aber im Unterschied zur erfindungsgemäßen Quelle nicht, oder nur in sehr geringem Maße spektral durchstimmbar. Zudem sind wir zuversichtlich, mit unserer Quelle nach einigen weiteren Optimierungsschritten noch deutlich höhere THz-Leistungen erzeugen zu können.

In diesem Kapitel beschreiben wir zuerst (4.1) die Komponenten, die in unserem Demonstrator verwendet werden. Danach diskutieren wir den Aufbau des Demonstrators (4.2) und zeigen erste experimentelle Ergebnisse (4.3).

Komponenten der erfindungsgemäßen Vorrichtung (in einigen Ausführungsbeispielen)

Die nachfolgend beschriebenen "Komponenten" sind als Komponenten im Sinne von Komponenten oder Mitteln der Vorrichtung oder eigenständiger neuartiger Einzelkomponenten davon oder im Sinne von Verfahrensschritten als Teile des erfindungsgemäßen Verfahrens zu verstehen.

Weitere Merkmale, Einzelheiten und Vorteile der Erfindung ergeben sich aus dem Wortlaut der Ansprüche sowie aus der folgenden Beschreibung von Ausführungsbeispielen anhand der Zeichnungen. Es zeigen:

Fig. 1     ein elektromagnetisches Spektrum;

Fig. 2    den Anstieg der Terahertz-Veröffentlichungen 1986 bis heute;

Fig. 3    Leistungsdaten existierender THz-Quellen (nach Prof. Allen, Universität von Santa Barbara);

Fig. 4    ein Beispiel für einen Wellenleiter, bei dem verschiedene Materialien verwendet wurden;

Fig. 5    die Polungsstruktur eines oberflächenemittierenden PPLNs (vereinfachtes Design);

Fig. 6    die periodische Polung unter einem Winkel α geneigt (linkes Bild), Schachbrett Kristalltyp mit 2D Polung (rechtes Bild);

Fig. 7    ein VECSEL-Spektrum im Zwei-Farben und Mehr-Farben Betrieb (oben) und einen aktuellen Aufbau für intrakavitäre THz-Erzeugung mit einem nichtlinearen Kristall (unten);

Fig. 8    emittierte THz-Ausgangsleistung des TPPLNs und die Anzahl der oszillierenden Laserlinien bei verschiedenen Ausgangsleistungen;

Fig. 9    vom TPPLN emittierte THz-Ausgangsleistung, welche mit einer verbesserten THz-Optik gebündelt und mit einer Golay Zelle detektiert wurde;

Fig. 10   THz-Ausgangsleistung bei f= 675 GHz und optimierter Resonatorkonfiguration;

Fig. 11a  verschiedene Halbleitermaterialien und Wellenlängen, mit denen sich Hablleiter-Scheibenlaser verwirklichen lassen;

Fig. 11b  Gittekonstanten und Bandlückenenergien einiger Hableiter für den sichtbaren bis infraroten Wellenlängenbereich;

Fig. 12   Zwei-Farben VECSEL mit optischen Elementen (hier: Linsen) im Resonator;

Fig. 13   Laserstrahlung des VECSELs wird mit der eines externen Lasers in einem nichtlinearen Material, welches sich in dem VECSEL Resonator befindet, überlagert; nicht Teil der Erfindung;

Fig. 14   Zwei VECSEL in einem gemeinsamen Resonator; nicht Teil der Erfindung;

Fig. 15   Zwei VECSEL mit getrennten Resonatoren; das nichtlineare Material befindet sich im Kreuzungspunkt beider Laserresonatoren; nicht Teil der Erfindung;

Fig. 16a  Die Laserstrahlung zweier VECSEL wird extrakavitär überlagert und auf ein oder mehrere nichtlineare Materialien, welche sich in einem weiteren externen Resonator befinden, gelenkt; nicht Teil der Erfindung;

Fig. 16b  Erweiterter, aktueller Aufbau für intrakavitäre THz-Erzeugung mit einem nichtlinearen Kristall und zusätzlichem hochreflektierenden (R>99%), konkaven Spiegel, der die ausgekoppelte Leistung wieder exakt in den Resonator zurückreflektiert;

Fig. 17   unterschiedliche Möglichkeiten, die THz-Strahlung von der optischen Strahlung zu trennen;

Fig. 18   eine erfindungsgemäße Auskoppelstruktur; und

Fig. 19   exemplarische Möglichkeiten der QPM,

## Vertical External Cavity Surface Emitting Laser (VECSEL)

Ein VECSEL besteht aus einer Halbleiterstruktur, die sich aus zwei unterschiedlichen Schichtenfolgen zusammensetzt. Der erste Bereich der Struktur besteht aus einer Schichtenfolge von Quantenfilmen, die für die Lasertätigkeit zuständig sind, gefolgt von einem darunterliegenden Bragg-Spiegel. Der VECSEL-Chip selbst bildet somit einen Spiegel des Laserresonators, während sich alle weiteren Spiegel außerhalb des Halbleitermaterials befinden. Mittels eines Pumplasers wird das Halbleitermaterial optisch angeregt. Alternativ kann die Anregung auch auf elektrischem Wege erreicht werden. Durch eine geeignete Resonatorkonfiguration kann eine Laseremission erzielt werden.

Durch den Einsatz von frequenzfilternden Elementen innerhalb des Resonators ist es möglich, das Emissionsspektrum des Lasers auf gewisse Frequenzen innerhalb seines Gewinnspektrums zu beschränken. Ein solches Element ist z.B. ein Etalon, mit dem es, bei geeigneter Wahl möglich ist, das Emissionsspektrum auf eine oder mehrere Frequenzen zu beschränken. Bei Zwei- oder Mehrfarben-Emission ist es möglich, mittels nichtlinearen optische Elemente zur Frequenzkonversion (SHG, THG, Differenzfrequenzmischung (DFG)) neue Emissionswellenlängen zu generieren.

## Nichtlineare Kristalle zur Frequenzkonversion

Nichtlineare Kristalle eignen sich zur erfindungsgemäßen Frequenzkonversion, d.h. zur Frequenzvervielfältigung bzw. Aufwärtsmischung, wie auch zur Differenzfrequenzerzeugung. Ausschlaggebend dafür ist ihr großer $\chi^{(2)}$-Faktor, der als elektrische Suszeptibilität 2. Ordnung bezeichnet wird. Dadurch ist es möglich, eine Frequenzkonversion des eingestrahlten Laserlichtes durchzuführen, sofern die Laserintensität ausreichend hoch ist, um ein messbares, konvertiertes Ausgangssignal zu erzeugen. Als nichtlineares Material kommen unterschiedlichste Materialzusammensetzungen in Frage, wobei vorher für jede Anwendung genau zu prüfen ist, welcher der zur Verfügung stehenden Materialien sich am besten eignet. Dabei ist z.B. auf die jeweilige Absorption der einzelnen Frequenzen innerhalb des Kristalls, wie auch auf die Phasenanpassung zwischen den erzeugenden und erzeugten elektromagnetischen Strahlungen zu achten. Letzteres stellt eine nicht triviale Herausforderung dar, denn eine ungenügende Phasenanpassung führt zu einem stark verminderten Ausgangssignal, da sich die erzeugten Frequenzanteile durch destruktive Interferenz wieder abschwächen oder vollständig auslöschen. Um eine Phasenanpassung zu gewährleisten, wurden drei Techniken untersucht. Im Ergebnis hat sich bzgl. der Erfindung gezeigt, dass: Erstens, kann eine Anpassung durch Doppelbrechung des Kristalls erreicht werden, zweitens durch eine Quasi-Phasenanpassung (QPM) und drittens durch eine Wellenleiterkonfiguration.

**Anpassung über Doppelbrechung**

Viele nichtlineare Kristalle weisen doppelbrechende Eigenschaften auf, d.h., der Brechungsindex hängt von der Polarisationsrichtung der elektromagnetischen Welle relativ zu den Kristallachsen ab. Hierbei wird zwischen ordentlichen und außerordentlichen Strahl unterschieden. Wird ein doppelbrechender Kristall unter einem gewissen Winkel geschnitten, so kann der effektive Brechungsindex des außerordentlichen Strahls als Funktion des Schnittwinkels verändert werden. Mit diesem Prinzip ist Phasenanpassung zu erreichen.

**Quasi-Phasenanpassung**

QPM kann -zur Realisierung der Erfindung- auch erzielt werden, indem sich gegenseitig orientierte ferroelektrische Domänen in einem Kristall in dem Abstand zueinander abwechseln, der der halben Wellenlänge des einfallenden Laserlichtes im Material entspricht. Durch die periodische Umpolung der Domänen wird eine Schwächung der erzeugten Frequenz durch destruktive Interferenz vermieden und die erzeugte Intensität der elektromagnetischen Strahlung nimmt mit der Weglänge im Kristall zu. Ein bekannter Vertreter, neben vielen anderen Materialien ist periodisch gepoltes Lithiumniotiat (PPLN). PPLN wurde in der ersten Demonstration der hier zum Patent angemeldeten Technologie verwendet und wird weiter unten beschrieben.

**Wellenleitergeometrie**

Eine erfindungsgemäße Phasenanpassung kann auch erreicht werden, indem das nichtlineare Material strukturiert wird um eine Wellenleitergeometrie zu realisieren. Ziel einer solchen Strukturierung ist es zu erreichen, dass im Wellenleiterbereich der effektive Brechungsindex des nichtlinearen Materials für die Laserwellenlängen und der effektive Brechungsindex des nichtlinearen Materials für die THz-Strahlung identisch ist, bzw. dass diese effektiven Brechungsindizes möglichst wenig voneinander abweichen. Um dieses zu auszuführen stehen sämtliche in Lehrbüchern beschriebene Wellenleiterkonfigurationen zur Verfügung (siehe z.B. Karl J. Ebeling, Integrierte Optoelektronik, Springer, Berlin, 1992). Beispiele hierfür sind aufliegende Streifenwellenleiter, bündig versenkte Streifenwellenleiter, vollständig versenkte Streifenwelleleiter, Rippenwellenleiter, invertierte Rippenwellenleiter, Wellenleiter mit dielektrischem Laststreifen, Wellenleiter mit metallischen Laststreifen. Es ergeben sich aber noch unzählige weitere Möglichkeiten, da das nichtlineare Material (oder die nichtlinearen Materialien) zur Realisierung eines Wellenleiters auch mit anderen Materialien kombiniert werden können, die einen sehr kleinen oder einen verschwindenden nichtlinearen Koeffizienten besitzen dafür aber einen für die Erreichung der Phasenanpassung zweckmäßigen Brechungsindex.

Exemplarisch zeigt Fig. 4 eine von vielen Möglichkeiten. Bei diesem Beispiel wurde angenommen, dass das Material im Zentrum für die Laserstrahlung einen Brechungsindex $n_{Las}$ besitzt, der größer ist als der Brechungsindex für die THz-Strahlung $n_{THz}$ (Dies kann jedoch auch genau umgekehrt sein. Die genauen Verhältnisse sind abhängig vom Material und von den beteiligten Wellenlängen). Da in diesem Beispiel die Laserstrahlung eine kleinere Wellenlänge besitzt als die THz-Strahlung wird sie im Wesentlichen in diesem Material geführt, d.h. die Mode der Laserstrahlung erstreckt sich kaum in die Nachbarmaterialien. Die THz-Strahlung besitzt jedoch eine vergleichsweise große Wellenlänge, weshalb sich die Mode der THz-Strahlung in die Nachbarmaterialien erstreckt. Im gezeigten Fall wurden benachbarten Materialien gewählt, die einen hohen Brechungsindex $n_{Nachbar}$ für THz-Strahlung besitzen, so dass $n_{Nachbar} > n_{Las}$. So wird der effektive Brechungsindex für die THz-Strahlung dem effektiven Brechungsindex für die Laser-Strahlung angepasst.

Es sind zudem auch Wellenleiter und/oder nichtlineare Materialien möglich, die photonische Kristallstrukturen beinhalten oder die auf sogenannten Metamaterialien mit negativem Brechungsindex beruhen.

Für eine große Konversionseffizienz ist eine hohe Intensität der Laserstrahlung im Kristall notwendig. Bedauerlicherweise besitzen alle Materialien eine Zerstörschwelle. Dieser Effekt wird bei Lithiumniobat als "photorefraktiver Effekt" oder "optischer Schaden" bezeichnet und ist in A. Ashkin, G. D. Boyd, J. M. Dzieduc, R. G. Smith, A. A. Ballmanand 3. J. Levinstein, and K. Nassau, "Optically-induced refractive index inhomogeneities in LiNbO3 and LiTaO3", Appl. Phys. Lett., vol. 9, 1966, beschrieben. Aufgrund der hohen Laserintensität innerhalb des Kristalls zeigt sich eine Änderung in dem örtlichen Brechungsindex und Absorptionsverhalten, welches den Laserstrahl beugt und eine Beendigung der Laseraktivität zur Folge hat. Allerdings ist dieser Effekt reversibel und kann durch starkes Aufheizen des Kristalls auf Temperaturen um die 170 °C oder höher, reduziert werden. Dadurch steigt jedoch der Aufwand zur Temperaturstabilisierung deutlich. Auf der anderen Seite kann die Stärke des optischen Schadens durch die Dotierung des LN mit MgO reduziert werden. Daher kann es für eine verbesserte Effizienz günstig sein MgO dotiertes LN (das Material, welches erfindungsgemäß auch genutzt wird) als Kristallmaterial zu verwenden.

Während LN vielversprechend für die Anwendung der Differenzfrequenzerzeugung (DFG) aufgrund seines großen nichtlinearen Koeffizienten ist, verhindert gleichzeitig seine starke Absorption für THz-Wellen eine Verwendung in einem kollinearen Aufbau. Um diesem Problem zu begegnen wurde erfindungsgemäß auch ein oberflächenemittierender, intrakavitärer THz-DFG Entwurf genutzt. Oberflächenemission von kohärenter THz-Strahlung, welche durch einen DFG-Prozess erzeugt wurde, kann mit einem PPLN-Kristall erzeugt werden.

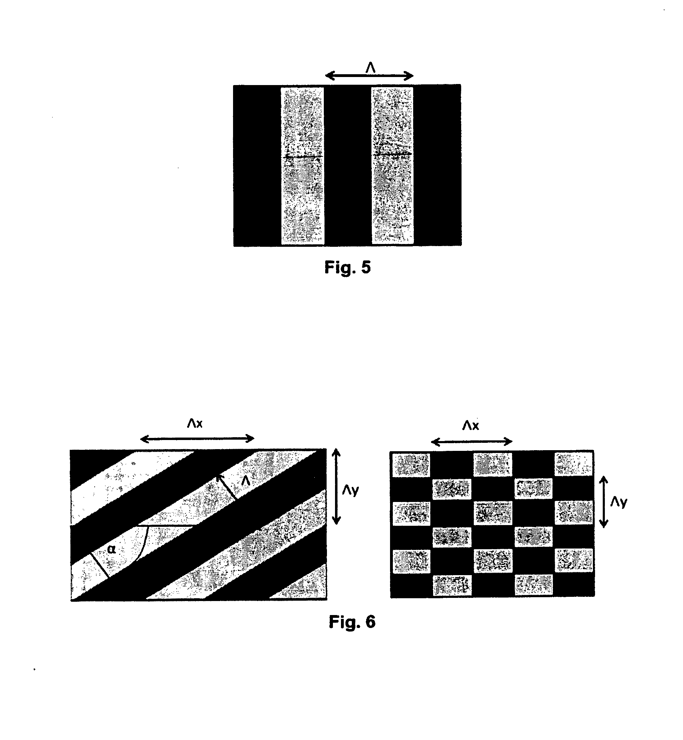

Das einfachste Design eines PPLNs ist in Fig. 5 gezeigt. Für eine effiziente Oberflächenemission sollte die Polungsperiode λ folgendermaßen gewählt werden:

$$\Lambda = \frac{\lambda_{THz}}{n_{IR}}$$

Wobei $n_{IR}$ der Brechungsindex der IR-Welle und $\lambda_{THz}$ die Freiraumwellenlänge ist.

Um destruktive Interferenz der generierten THz-Abstrahlung, bei Verwendung dieses vereinfachten Designs, zu vermeiden und um eine hohe THz-Ausgangsleistung zu erhalten, ist es notwendig, einen sehr geringen Durchmesser der Laserstrahlung innerhalb des PPLNs zu verwenden. Allerdings ist die sinnvolle Kristalllänge durch die Divergenz des Laserstrahls begrenzt. Hierbei ist zu erwähnen, dass je kleiner der Strahldurchmesser gewählt wird, eine umso größere Strahldivergenz daraus resultiert.

Während das einfache PPLN Design, das in Fig.. 5 gezeigt ist, für VECSEL-Systeme mit geringer IR-Leistung ausreicht, basiert der hier erstmals vorgestellte DFG THz-Demonstrator auf einem erweiterten Kristalldesign. Ein geneigter periodisch gepolter Lithiumniobat (TPPLN) Kristall wurde verwendet, um nicht mehr durch zu kleine IR-Strahldurchmesser limitiert zu sein. Diese Struktur ist geneigt in Bezug auf die Kristalloberfläche. Somit besteht auch eine periodische Polung in Richtung der abgestrahlten THz-Welle. Folglich wird dadurch die destruktive Interferenz der THz-Welle kompensiert und der IR-Strahldurchmesser kann deutlich größer gewählt werden, ohne eine Verminderung der Konversionseffizienz. Auf der linken Seite in Fig. 6 ist eine TPPLN Struktur gezeigt. Zu bemerken ist an dieser Stelle, dass auch mit einem Schachbrettmuster, wie es auf der rechten Seite von Fig. 6 gezeigt ist, eine periodische 2D Polung verwirklicht werden kann, deren Verhalten vergleichbar mit der TPPLN Struktur ist. Beide sind erfindungsgemäß nutzbar.

Für eine hohe Konversionseffizienz sollten die Parameter folgendermaßen bestimmt werden:

$$\tan(\alpha) = \frac{n_{THz}}{n_{IR}},$$

$$\Lambda = \frac{\lambda_{THz}}{n_{IR}}\cos(\alpha),$$

$$\Lambda_x = \frac{\lambda_{THz}}{n_{IR}}, \Lambda_y = \frac{\lambda_{THz}}{n_{THz}}.$$

Wobei $n_{IR}$ der Brechungsindex der IR-Strahlung, $n_{THz}$ der THz-Brechungsindex und $\lambda_{THz}$ die Freiraumwellenlänge der THz-Abstrahlung ist. Weiterhin ist $\alpha$ der Neigungswinkel und A die Polungsperiode.

In den letzten Jahren wurde gezeigt, dass elektro-optische Polymere einen nichtlinearen $\chi^{(2)}$- Koeffizienten besitzen, der ausreicht um mittels Differenzfrequenzerzeugung (bzw. optische Gleichrichtung) THz-Wellen zu erzeugen (siehe beispielsweise L. Michael Hayden, A. M. Sinyukov, M. R. Leahy, P. Lindahl, J. French, W. Herman, M. He, and R. Twieg, "New materials for optical rectification and electro-optic sampling of ultra-short pulses in the thz regime", J. Polymer Sci. B. Polymer Phys, vol. 41, pp. 2492-2500, 2003; A. M. Sinyukov and L. Michael Hayden, "Efficient electro-optic polymers for thz applications", J. Phys. Chem. B, vol. 108, pp. 8515-8522, 2004; Xuemei Zheng, Alexander Sinyukov, and L. Michael Hayden, "Broadband and gap-free response of a terahertz system based on a poled polymer emitter-sensor pair", Applied Physics Letters, vol. 87, no. 8, pp. 081115, 2005).

Damit eröffnet sich eine weitere Materialklasse die erfindungsgemäß als nichtlineares Medium eingesetzt werden kann.

Auch Silizium kann als nichtlineares Medium verwendet werden. Silizium besitzt normalerweise keinen nichtlinearen $\chi^{(2)}$-Koeffizienten. In Rune S. Jacobsen, Karin N. Andersen, Peter I. Borel, Jacob Fage-Pedersen, Lars H. Frandsen, Ole Hansen, Martin Kristensen, Andrei V. Lavrinenko, Gaid Moulin, Haiyan Ou, Christophe Peucheret, Beáta Zsigri, and Anders Bjarklev, "Strained silicon as a new electro-optic material", Nature, vol. 441, pp. 199-202, 2006, wird gezeigt, dass in Silizium ein signifikanter nichtlinearer Koeffizient durch eine verspannungsinduzierte Symmetriebrechung erreicht werden kann. Verspanntes Silizium kann demnach als nichtlineares Medium zur THz-Erzeugung eingesetzt werden.

## Frequenzkonversion innerhalb einer Kavität (vornehmlich) SHG

Für die Frequenzkonversion bietet sich die Anordnung des nichtlinearen Elementes innerhalb des Resonators an, da hier die optische Intensität signifikant höher ist, als bei der Verwendung des ausgekoppelten Laserstrahls. Dadurch erhöht sich die Konversionseffizienz um ein Vielfaches, denn die nicht konvertierte Laserleistung geht nicht verloren, sondern wird durch die Resonatorspiegel zurück durch den Kristall reflektiert. Somit genügt bereits eine geringe Konversionseffizienz bei einfachem Durchlauf durch den Kristall, um eine hohe resultierende Frequenzkonversionseffizienz zu erzielen. Einziger Unterschied zu einem Laser ohne nichtlineares Element im Resonator besteht darin, dass ein Resonatorspiegel durch einen, mit dichromatischen Eigenschaften ausgetauscht werden muss, um die durch Frequenzkonversion erzeugte Welle aus dem Resonator auszukoppeln.

## Aufbau des Demonstrators

Wir wollen hier nachdrücklich darauf hinweisen, dass der hier vorgestellte experimentelle Aufbau lediglich eine exemplarische Ausführungsform darstellt und andere Ausführungsformen oder Ausführungsbeispiele ebenso realisierbar sind.

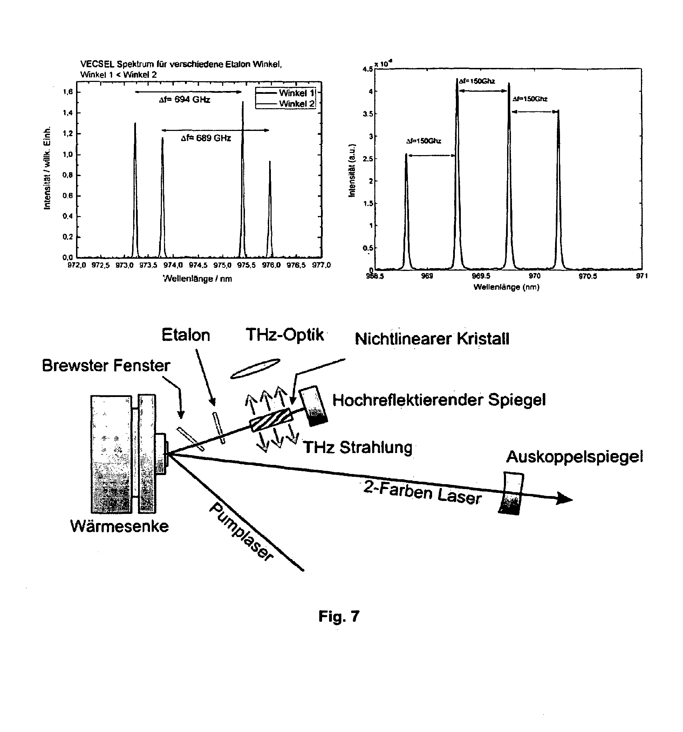

Die schematische Zeichnung in Fig. 7 zeigt den in unserem bereits realisierten Demonstrator verwendeten Aufbau des Zwei-Farben VECSELs, der einen nichtlinearen Kristall und THz-Optiken enthält. Das nichtlineare Material besteht aus Lithiumniobat (LN) mit schräger, periodischer Polung (TPPLN).

Der verwendete Laseraufbau besteht aus einem V-förmigen Resonator, der durch zwei Spiegel begrenzt wird, einem konvexen Auskoppelspiegel mit einer Reflektivität von 97% und einem hochreflektierenden, planaren Spiegel mit einer Reflektivität von über 99%. Das aktive Lasermedium befindet sich auf einer Wärmesenke im Faltungspunkt des Resonators und wird von einem Pumplaser, der bei einer Wellenlänge von 810 nm emittiert, gepumpt.

Weitere verwendete Elemente sind ein Etalon zur Erzeugung von zwei oder mehreren Wellenlängen, wie die beiden oberen Spektren in Fig. 7 zeigen. Durch Neigen des Etalons ist es auch möglich die Differenzfrequenz in gewissen Grenzen zu verschieben. Ebenfalls zur Anwendung kamen ein Brewsterfenster zur Einstellung der Polarisation der Laserstrahlung und THz-Optiken zur Bündelung und Fokussierung der emittierten THz-Wellen auf einen Detektor. Die THz-Strahlung konnte sowohl mit einem Bolometer, einer Golay Zelle und einem pyroelektrischen Detektor nachgewiesen werden. Der Detektor und die zweite THz-Linse sind nicht in der Fig. 7 enthalten.

Die Wellenlänge wie auch der Frequenzabstand der Linien kann durch Neigen des Etalons verändert werden.

Die Platzierung des nichtlinearen Kristalls erfolgte nahe an dem hochreflektierenden Spiegel, denn hier erreicht der Laserstrahl innerhalb des Resonators seinen geringsten Durchmesser.

Mit der verwendeten, erfindungsgemäßen schrägen Ausrichtung der Polung des nichtlinearen Kristalls kann die Auskopplung der THz-Strahlung aus dem Kristall in vorteilhafter Weise im rechten Winkel zur Propagationsrichtung des Laserstrahls erfolgen. Die meisten der nichtlinearen Kristalle sind transparent für die Laserstrahlung aber mehr oder weniger absorbierend für THz-Wellen. Eine Auskopplung der THz-Strahlung aus einer der Seitenflächen des Kristalls reduziert die Wegstrecke, die die THz-Welle zurücklegen muss und infolgedessen auch die Absorption innerhalb des Kristalls. Weiterhin bedeutet eine seitliche Auskopplung der elektromagnetischen THz-Welle aus dem Kristall auch einen deutlich einfacheren Zugang zu der Strahlung, wie auch die Positionierung der THz-Optiken erheblich vereinfacht wird, da sich in diesem Bereich keine Optiken des Laserresonators befinden.

Um eine effiziente Erzeugung der THz-Strahlung zu gewährleisten, muss zwischen der Laserstrahlung und der THz-Welle eine Phasenanpassung vorliegen. Erfindungsgemäß wurde dies durch Verwendung periodisch gepolter Materialien erzielt. Daher wurde in diesem Aufbau periodisch gepoltes Lithiumniobat verwendet, welches mit MgO dotiert wurde, um die Zerstörschwelle anzuheben.

## Erste Experimentelle Ergebnisse

In diesem Abschnitt werden die experimentellen Ergebnisse präsentiert, die bisher mit diesem Demonstrator erzielt wurden.

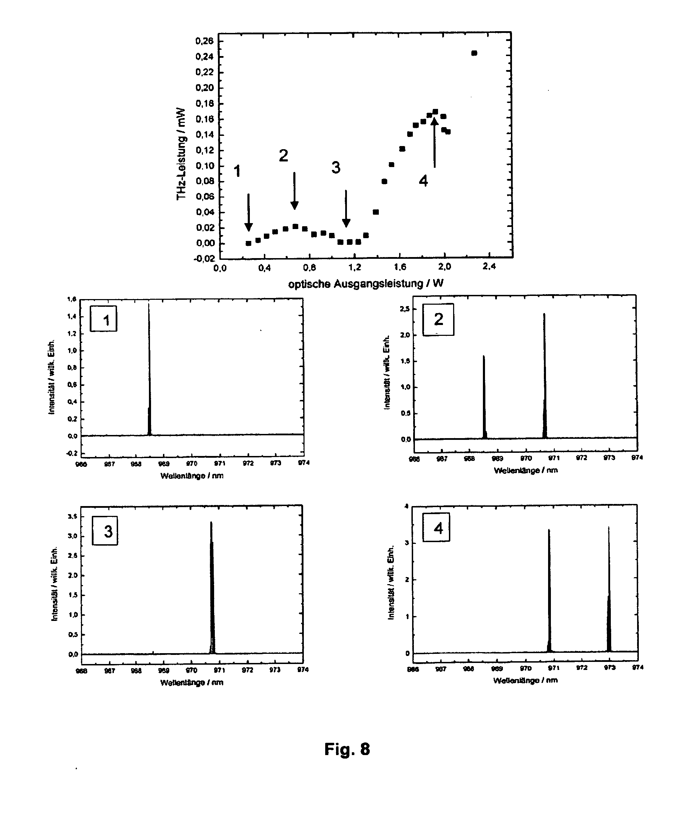

In Fig. 8 ist das erste Ergebnis einer Messung der erzeugten THz-Strahlung als Funktion der optischen Leistung gezeigt, die aus der Laserkavität ausgekoppelt wurde. Als THz-Detektor kam ein Bolometer zum Einsatz, mit dem eine maximale THz-Ausgangsleistung von 0,24 mW gemessen werden konnte. Zusätzlich sind vier Spektren für verschiedene Ausgangsleistungen dargestellt, die mit einem optischen Spektralanalysator aufgenommen wurden.

Diese Spektren beweisen, dass das gemessene Detektorsignal nur aus der THz-Strahlung herrührt, die mittels Differenz-Frequenz-Generation (DFG) im TPPLN erzeugt wurde. Es ist eindeutig zu sehen, dass das Bolometersignal nur dann von Null verschiedene Werte annimmt, wenn beide Laserlinien gleichzeitig präsent sind (Spektren #2 und #4). Bei den Ausgangsleistungen, bei denen die Spektren #1 und #3 aufgenommen wurden, oszillierte nur eine Laserlinie und damit findet kein DFG-Prozess statt und es wird somit keine THz-Welle erzeugt. Das Signal verschwindet und es ist lediglich das vorhandene Rauschen messbar.

Mit erhöhter optischer Ausgangsleistung und damit erhöhter Leistung innerhalb der Laserkavität ist eine thermisch bedingte Rotverschiebung der Laserlinien zu beobachten. Diese Verschiebung hat keinen Einfluss auf den DFG-Prozess, da die Differenzfrequenz konstant bleibt. Diese hängt nur von dem intrakavitären Etalon und nicht von der Laserleistung ab.

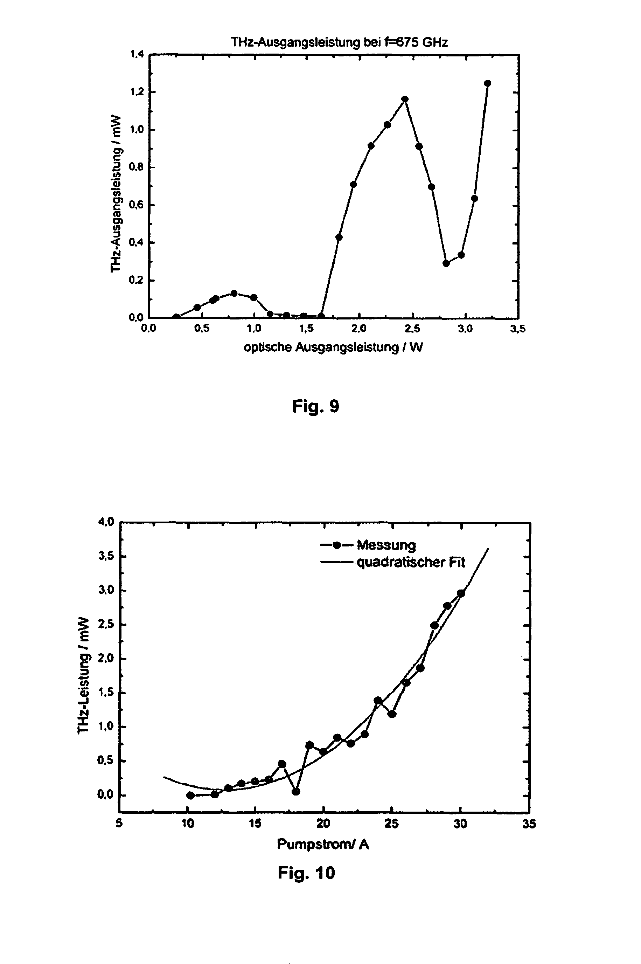

Nach einer Designverbesserung der THz-Optiken, bei der die sphärische Linse direkt vor dem TPPLN durch eine Zylinderlinse ersetzt wurde, kann ein größerer Teil der emittierten THz-Leistung aufgefangen und auf den Detektor, in diesem Fall eine Golay Zelle, fokussiert werden. Dieses führt zu einem sehr viel größeren THz-Signal von rund 1,3 mW, wie es in Fig. 9 dargestellt ist. Zu beachten ist an dieser Stelle, dass lediglich die Strahlung aufgefangen wird, die von einer der beiden Seiten des TPPLN emittiert wird

Nach einer weiteren Designverbesserung, bei der in diesem Fall die Resonatorkonfiguration optimiert wurde, konnte die THz-Ausgangsleistung von 1,3 mW auf 3 mW verbessert werden, wie die Messung in Fig. 10 zeigt. Erreicht wurde dieses durch einen weiteren, konkaven, hochreflektierenden Spiegel außerhalb des eigentlichen Resonators. Der Spiegel wurde dabei so platziert, dass er das aus der Kavität ausgekoppelte Laserlicht wieder exakt auf den Laserchip im Faltungspunkt des Resonators zurück reflektiert. In dieser Anordnung ist der vorher externe konkave Spiegel quasi ein Teil des Resonators geworden. Anhand dieser Maßnahme, die nur ein Zwischenstadium zu einer effizienteren Resonatorkonfiguration darstellt, konnte gezeigt werden, dass die optische Laserleistung im Resonator noch deutlich erhöht werden kann, was sich in einer signifikanten Steigerung des THz-Signals äußert.

Trotz der beeindruckenden bereits erzielten Ergebnisse soll hier nochmals darauf hingewiesen werden, dass die vorgestellte experimentelle Realisierung nur Beispielcharakter hat. Es wurden bisher weder endgültig optimierte VECSEL Geometrien, Lasermaterialien, nichtlineare Kristalle, oder Extraktionskonfigurationen verwendet. Die erfindungsgemäßen, weiteren Verbesserungen und Erweiterungen unserer laserbasierten Quelle für THz- und Milimeterwellen werden in dem nachfolgenden Abschnitt diskutiert.

### Ausführungsarten

Die zentrale Idee unserer Patentanmeldung ist mittels eines nichtlinearen Mediums, das innerhalb des Laserresonators eines Lasers positioniert ist, über Differenzfrequenzerzeugung Terahertz-Strahlung zu generieren. Diese Terahertz-Strahlung kann dann über eine geeignete THz-Optik extrahiert und geführt werden.

Im Folgenden werden jeweils separat Ausführungsarten von Lasermedien, Resonatorkonfigurationen, nichtlinearen Medien und THz-Optiken dargestellt.

### Lasermedien

### Halbleitermaterialien

Bei der erfindungsgemäßen Ausführung des Patents ist vornehmlich daran gedacht, halbleiterbasierte Lasermedien zu verwenden; d.h. Laser wie sie unter dem englischen Begriff "Vertical External Cavity Surface Emitting Laser (VECSEL)" oder dem deutschen Begriff "Halbleiter Scheibenlaser" bekannt sind. Die spektrale Lage des Gewinnbereichs kann dabei über das verwendete Materialsystem und strukturelle Parameter der einzelnen Halbleiterschichtenschichten (Materialzusammensetzung und Abmessung) eingestellt werden. Da bezüglich der Laserwellenlängen keine prinzipielle Einschränkung für die THz-Erzeugung existiert, ist es insbesondere möglich, die aktive Struktur so zu entwerfen, dass ein möglichst preisgünstiger und/oder leistungsfähiger Pumplaser verwendet werden kann.

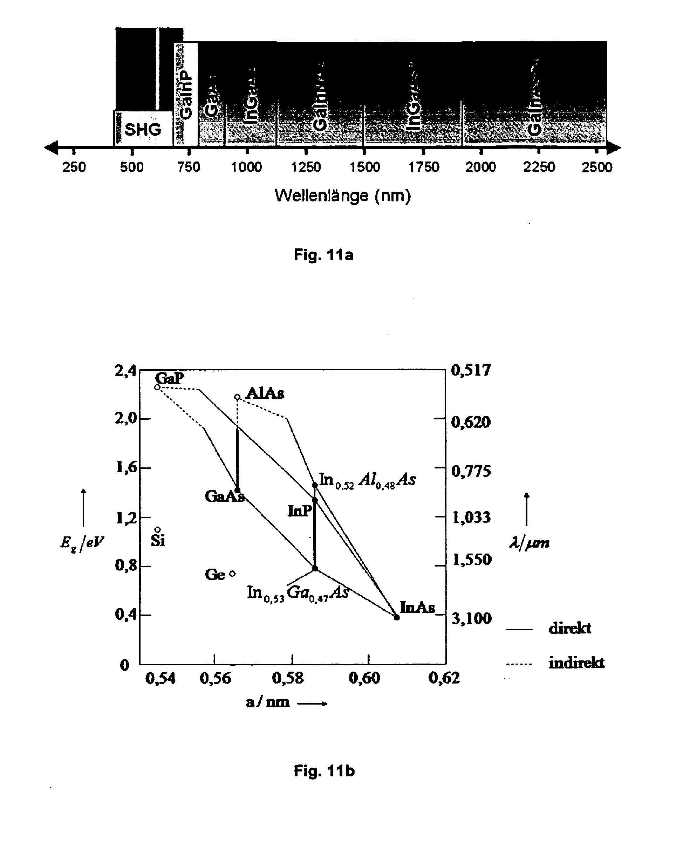

Prinzipiell können die Laserwellenlängen frei in einem weiten Bereich gewählt werden. Der Spektralbereich erstreckt sich von sichtbaren Frequenzen bis hin zu 6 Mikrometern. Fig. 11a zeigt exemplarisch welche Materialsysteme für Laserwellenlängen zwischen 700 nm und 2,5 $\mu$m herangezogen werden können. Diese Auftragung hat jedoch nur Beispielcharakter. Sie ist keinesfalls vollständig, d.h. eine bestimmte Laserwellenlänge kann auch durch die Verwendung eines anderen, hier nicht gezeigten Materialsystems realisiert werden.

Dabei ist in der Regel darauf zu achten, dass die verschiedenen Halbleitermaterialien innerhalb der VECSEL-Struktur unverspannt oder nur mit einer gezielt eingestellten Verspannung aufeinander abgeschieden werden können.

Voraussetzung ist eine ähnliche Gitterkonstante. Nur so ist eine hohe strukturelle Güte der Laserstruktur gewährleistet Fig. 11b zeigt exemplarisch die Gittekonstanten und Babdlückenenergien einiger Hableiter für den sichtbaren bis infraroten Wellenlängenbereich.

In dem unter 4.2 beschriebenen Demonstrator wurde ein VECSEL Aufbau gewählt, welcher identisch ist mit dem in der US 61/067,949 (Appl. No.) (Provisional Patent Application UA07-026) auf Seite 3-5 unter "Dual Wavelength VECSEL" beschriebenen, jedoch mit dem Unterschied, dass im hier vorgestellten Demonstrator noch ein nichtlinearer Kristall dicht vor den planaren, hochreflektierenden Spiegel eingebaut wurde.

### Laserkristalle

Es können auch so genannten Scheibenlaser verwendet werden. Als aktives Material werden in dieser Laserklasse dotierte Kristalle eingesetzt. Derzeit wird als Lasermaterial für Scheibenlaser vorwiegend Yb:YAG (Ytterbiumdotiertes Yttrium-Aluminium-Granat) verwendet, welches bei einer Laser-Wellenlänge von 1030 nm emittiert. Es gibt aber auch eine Vielzahl von anderen Materialien die bereits eingesetzt wurden oder in Zukunft eingesetzt werden können. Beispiele sind Nd bzw. Yb dotiertes YAG, YVO4 oder $LaSc_3(BO_3)_4$ (LSB), Yb:KYW, Yb:KGW, Yb:KLuW und Yb:CaGdAlO4 (Yb:CALGO), $Yb:Y_3Sc_2Al_3O_{12}$, $Yb^{3+}:Y_3Al_5O_{12}$, $Cr^{4+}: Y_3Sc_xAl_{5-x}O_{12}$. Die Laserwellenlänge und auch die optimale Pumpwellenlänge ändern sich mit dem verwendeten Material. Scheibenlaser emittieren Leistungen im Kilowatt-Bereich, so dass sehr hohe THz-Leistungen erzielt werden können, sofern der nichtlineare Kristall nicht beschädigt wird.

### Dotierte Gläser

Als Lasermedium können auch dotierte Gläser eingesetzt werden wie sie für die Herstellung von Faserlasern seit langem bekannt sind. Hierfür stehen eine Vielzahl von Dotieratomen aus der Klasse der seltenen Erden (Scandium, Yttrium, Lanthan, Cer, Praseodym, Neodym, Promethium, Samarium, Europium, Gadolinium, Terbium, Dysprosium, Holmium, Erbium, Thulium, Ytterbium und Lutetium) und verschiedene Glastypen (Quarzglas, Flouridglas, ZBLAN, INDAT,...) zur Verfügung.

### Resonatorkonfigurationen

Der Resonator ist das zentrale Element eines Lasers und hat einen entscheidenden Einfluss auf die Leistungsfähigkeit des Gesamtsystems. Aus der Literatur ist eine nahezu unüberschaubare Vielfalt an Resonatorkonfigurationen bekannt, da sich für jeden Anwendungszweck eine bestimme Resonatorkonfiguration als optimal erweist. Im Folgenden soll ein Überblick über die möglichen Resonatortypen gegeben werden, die erfindungsgemäß auch in dem zu patentierenden Gerät Einsatz finden können.

Generell können stabile, begrenzt stabile und instabile Resonatoren erfindungsgemäß eingesetzt werden.

### Stabiler Resonator

Resonatoren werden als stabil bezeichnet, wenn ein paraxialer Lichtstrahl in dem Resonator beliebig oft zwischen den Spiegeln hin und her reflektiert wird und den Resonator nicht mehr verlässt, sofern Beugungsverluste vernachlässigt werden. Allerdings gibt es Grenzen, in denen sich die geometrischen Abmessungen einer Resonatorkonfiguration nur bewegen dürfen, damit der Resonator noch stabil ist. An den Stabilitätsgrenzen wird ein Resonator sehr empfindlich für mechanische Veränderungen (Vibrationen) und Dejustierungen, d.h. in diesem Bereich kann ein Resonator leicht vom stabilen in den instabilen Bereich übergehen, was bei vielen Lasern dazu führt, dass die Lasertätigkeit unterbunden wird. Beispiele für stabile Resonatoren sind z.B. die semikonfokalen und konkav-konvexen, auf den Stabilitätsgrenzen, wie z.B. die plan-parallele, konzentrischen (sphärischen), konfokalen und hemisphärischen Konfigurationen.

### Begrenzt stabiler Resonator

Bei dieser Konfiguration wird eine Blende in den stabilen Resonator, vornehmlich in die Nähe eines oder mehrerer Spiegel gebracht, um eine Modenselektion zu erwirken. So kann z.B. erreicht werden, dass sich nur die Grundmode im Resonator ausbreitet, jedoch alle höheren longitudinalen und transversalen Moden Verluste erfahren und nicht anschwingen.

### Instabiler Resonator

Diese Resonatortypen sind so konstruiert, dass ein paraxialer Laserstrahl nach einer bestimmten Anzahl von Resonatorumläufen diesen wieder verlässt. Verwendet wird diese Konfiguration bei Lasersystemen die eine hohe Leistung bzw. Verstärkung aufweisen, da hier im Falle eines stabilen Resonators die Leistungsdichte auf den Spiegeln die Zerstörschwelle überschreiten kann.

**Ausführungsformen von Resonatoren**

Im einfachsten Fall kann ein linearer Resonator aus zwei Spiegel bestehen, zwischen denen die Lichtwelle hin und her schwingt und eine stehende Welle bildet. Es ist genauso möglich, beliebig viele Spiegel zwischen diese beiden Endspiegel zu platzieren und die stehende Lichtwelle damit in jede gewünschte Richtung umzulenken. Bekannte Resonatorkonfigurationen sind V- oder W-förmig. Es sind auch weitere "Faltungen" möglich.

Eine Sonderform einer linearen Laserkavität ist der Multipass-Resonator, bei dem das aktive Medium an unterschiedlichen Stellen durchlaufen wird. Dieses kommt dadurch zustande, dass der Laserstrahl an den Endspiegeln nicht in sich selbst zurück reflektiert wird, sondern etwas dazu versetzt und erst nach einer bestimmten Anzahl von Umläufen erreicht er wieder seinen Ausgangspunkt.

Eine weitere Bauform von Resonatoren ist der Ringresonator. Dabei entsteht keine stehende Welle durch Überlagerung der hin und rücklaufenden Lichtwelle erzeugt, sondern die Umlaufrichtung wird durch den Einsatz eines optischen Isolators innerhalb des Resonators oder eines hochreflektierenden Spiegels außerhalb des Resonators festgelegt. Es ist aber genauso möglich, auf diese beiden Elemente zu verzichten und zwei, in gegensätzliche Richtungen umlaufenden Wellen im Resonator zuzulassen.

Elemente, die innerhalb eines Laserresonators eingesetzt werden können, sind nicht nur auf das aktive Lasermaterial beschränkt, sondern es ist auch möglich, eine Vielzahl von unterschiedlichsten Komponenten einzusetzen. So können z.B. Linsen, Etalons, Brewsterfenster, polarisierende Elemente, zu denen der bereits genannte optische Isolator zählt, aber auch $\lambda/2$- oder $\lambda/4$ Platten, polarisierende Strahlteiler, etc verwendet werden. Weitere mögliche Elemente sind Pockelszellen und sättigbare Absorber, die zur Erzeugung eines Pulsbetriebes eingesetzt werden. Weitere Materialien können auch doppelbrechende oder nichtlineare Eigenschaften besitzen, wie einige Kristalle. Es ist auch denkbar in einem Resonator lichtführende Fasern einzusetzen, wie es unter anderem in einem Faserlaser angewendet wird.

Als weiterer Punkt sollen an dieser Stelle einige alternative Resonatorkonfigurationen genannt werden, die zum Teil von den gängigen Resonatortypen abweichen und in speziellen Bereichen eingesetzt werden. Dazu zählen Resonatoren, bei denen nicht die typischen Plan-, Konvex- oder Konkavspiegel als reflektierendes Element beinhalten, sondern Gradientenspiegel, Zylinder- oder Torusspiegel und Prismen. Es existieren auch Kombinationen aus Torus- und Zylinderspiegeln, sog. Hybridresonatoren, die unterschiedliche Stabilitätswerte in zwei senkrecht zueinander stehenden Raumrichtungen besitzen. Ebenfalls kann ein relativ neues optisches Element, das GRISM, eingesetzt werden. Dieses wird hauptsächlich zur Laserpulskompression verwendet und ist eine Kombination aus einem Prisma und einem optischen Gitter.

Bei der Auswahl der Spiegel für den Resonator können die Spiegel entweder ein breitbandiges Freqeunzverhalten aufweisen, oder auch ein extrem schmales, so dass sie beispielsweise nur die Laserwellenlänge reflektieren und für alle anderen Wellenlängen ein deutlich schlechteres Reflektionsvermögen aufweisen. Weiterhin existieren dichromatische Spiegel, die für zwei voneinander verschiedene Wellenlängen ein hochreflektierendes Verhalten aufweisen. Jede dieser Spiegeltypen kann für sich oder auch kombiniert in einem Laserresonator verwendet werden.

In der folgenden Tabelle sind die oben im Text aufgelisteten Beispiele nochmals zusammengefasst.

Resonatortypen:

Stabil:

- Semi-konfokal
- Konkav-konvex

Auf der Stabilitätsgrenze:

- Plan-parallel
- Konzentrisch (sphärisch)
- Konfokal
- Hemisphärisch

begrenzt (ein- und zweiseitig) stabil (z.B. mit Blende)

- jede stabile Resonatorkonfiguration

Instabile:

- unzählige Ausführungsformen

Gefaltete:

- V-förmig
- W-förmig
- weitere Formen

Elemente im Resonator:

- Linsen
- Sphärische und asphärische Spiegel
- Etalon, Brewster Fenster
- Polarisierende Elemente (opt. Isolator, $\lambda/2$- oder $\lambda/4$ Platten, polarisierender Strahlteiler)
- Pockelszelle
- doppelbrechendes oder nichtlineares Element
- lichtleitende Faser
- Beugungsgitter
- Prismen
- GRISMs

Alternative Resonatorkonfigurationen

- Prismen-Resonatoren
- mit Gradientenspiegeln
- Fourier-Transform Resonator
- Hybridresonatoren aus Torus- oder Zylinderspiegeln (unterschiedliche g-Parameter in zwei senkrecht zueinander stehenden Raumrichtungen)
- für rohrförmige Medien (mit Torusspiegeln)
- Multipass
- Ring
- dichromatische Spiegel
- aus lichtleitender Faser
- Wellenleiter

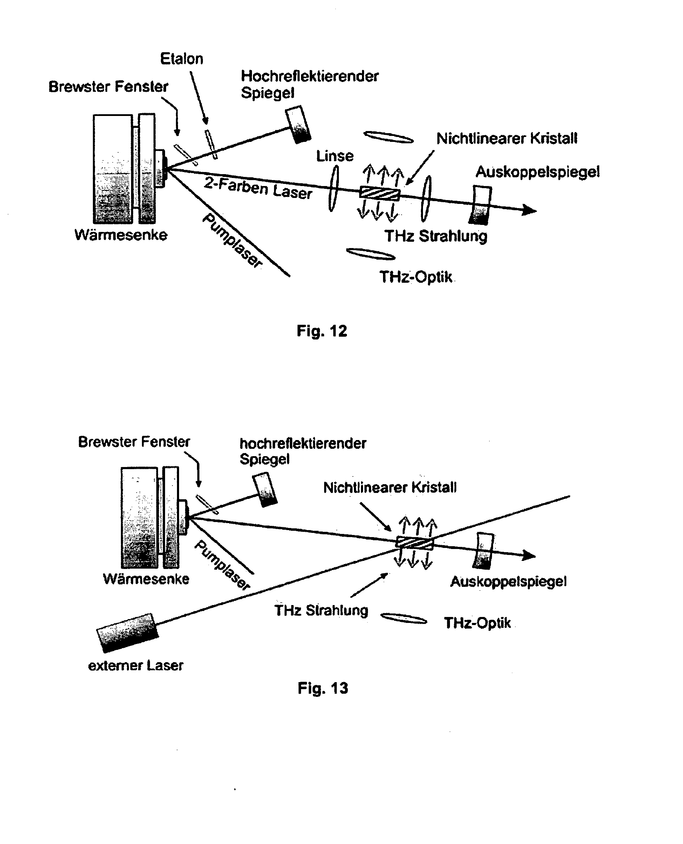

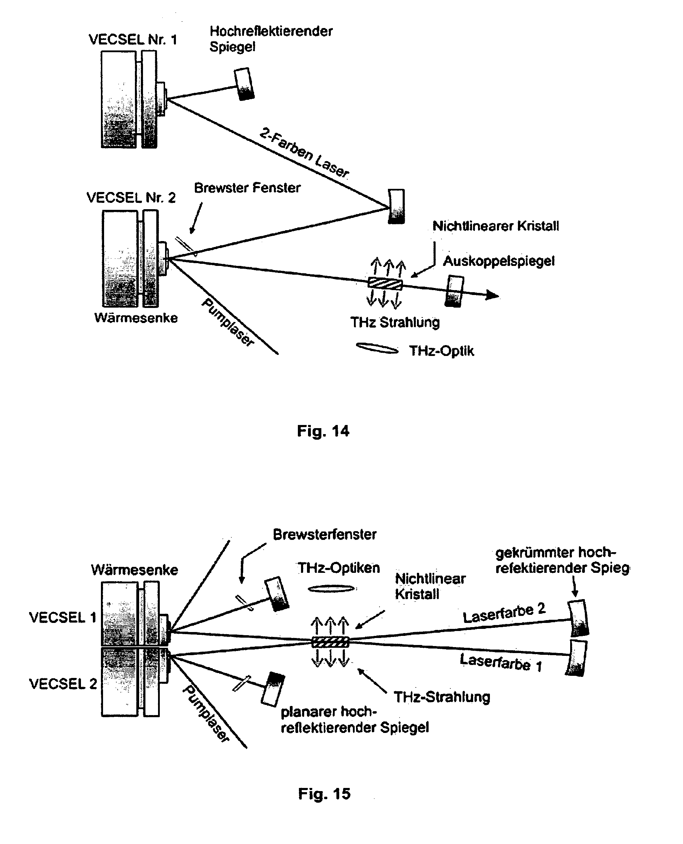

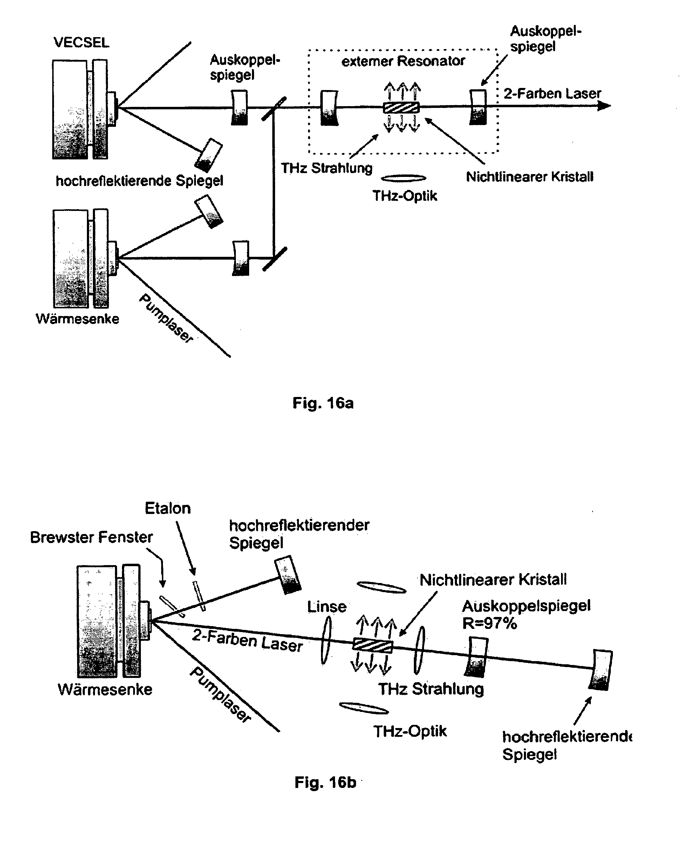

In den Fig. 12 bis 16b sind einige Ausführungsformen von Laserresonatoren gezeigt, die zur Erzeugung von THz-Strahlung gut geeignet sind. Allerdings sind auch alle oben beschriebenen Resonatortypen und Ausführungsformen, sowie Kombinationen daraus denkbar. Das umschließt ebenfalls die Verwendung der aufgelisteten Elemente, die in den Resonator eingebracht werden können. Die in Fig. 13-15 und 16a gezeigten Resonatortypen sind nicht Teil der Erfindung.

**THz-Optik**

Die Anforderung an die THz-Optik gliedert sich in drei Teile: Zunächst muss die THz-Strahlung effizient aus dem Resonator ausgekoppelt werden, indem diese von der IR-Welle getrennt wird. Dann ist die Strahlung in der Weise aus dem Kristall zu extrahieren, dass minimale Reflexionsverluste auftreten. Schließlich sind die THz-Wellen über Linsenoptiken so zu formen, dass ein kollimierter Strahl entsteht.

### Auskopplung aus dem Resonator

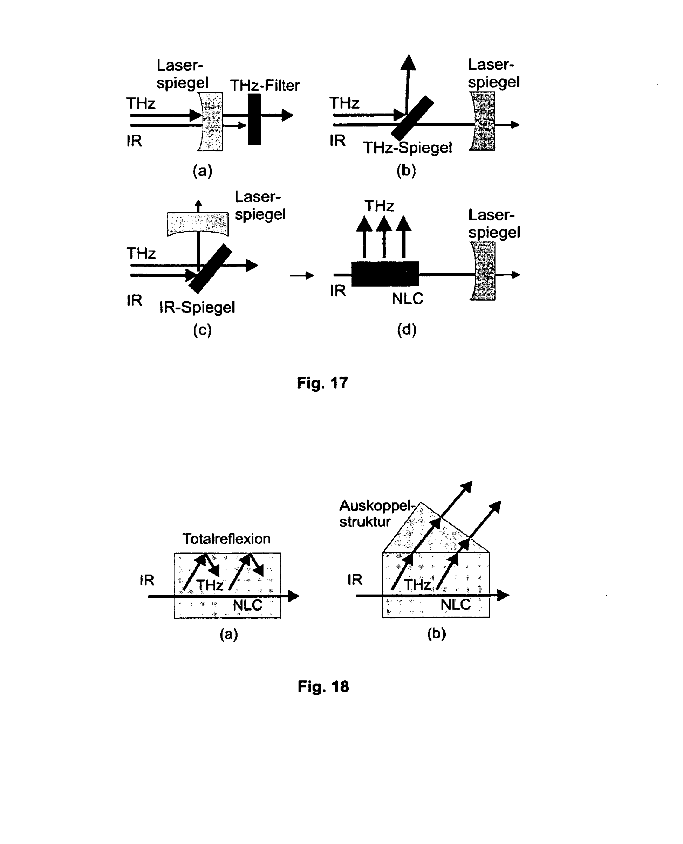

Falls die THz-Strahlung kollinear zur Resonatormode erzeugt wird, kann diese erfindungsgemäß entweder innerhalb des Resonators über einen THz-Spiegel von der optischen Welle separiert werden, oder die Trennung kann hinter dem Laserspiegel erfolgen, wie in Fig. 17 dargestellt wird. Hierfür bieten sich folgende Möglichkeiten an:

Bei kollinearer THz-Erzeugung kann ein externes Filter (Fig. 17a) oder ein resonatorinterner THz-Spiegel (Fig. 17b) oder ein resonatorinterner Spiegel für die optische Welle (Fig. 17c) verwendet werden. Alternativ kann ein oberflächenemittierender Kristall als Quelle der THz-Strahlung dienen (Fig. 17d).

Hinter dem Spiegel kann ein für THz-Strahlung transparentes Filter, welches die optische Welle absorbiert oder reflektiert zur Trennung der beiden Wellen verwendet werden. Dieses kann beispielsweise aus einem Polymer, einem beschichteten Glas oder einem Halbleiter bestehen. Alternativ kann auch eine Art optisches Gitter verwendet werden, welches die THz-Welle in eine andere Richtung reflektiert als die optische Welle.

Um die Strahlung innerhalb der Kavität zu trennen, kann ein THz-Reflektor verwendet werden, welcher transparent für die optische Welle ist. Hier bietet sich beispielsweise ein mit Indiumzinnoxid (ITO) oder mit einem dielektrischen THz-Spiegel beschichtetes Glas an. Alternativ kann ein Material verwendet werden, welches im THz-Bereich einen hohen Brechungsindex und damit eine hohe Reflektivität besitzt, welches für die optische Welle jedoch nur gering reflektierend ist. Dieser Reflektor kann entweder nur dem Zweck der THz-Auskopplung dienen oder auch als Etalon fungieren, um die spektralen Filterung der Laserlinien herbeizuführen.

Alternativ kann ein für die optische Welle hochreflektiver Spiegel, der im THz-Bereich gering reflektierend und transparent ist, innerhalb der Kavität eingesetzt werden.

Wird ein Kristall gewählt, in dem die THz-Erzeugung in der Weise geschieht, dass die Strahlung aus der Kristalloberfläche emittiert wird, sind die Wellen automatisch voneinander getrennt und keine weiteren Trennungsmaßnahmen sind notwendig. In Fig. 17 ist dieses veranschaulicht. Dies ist eine erfindungsgemäße, besonders bevorzugte Ausführungsform.

### THz-Extraktion-Optik

Da viele nichtlineare Kristalle über einen hohen Brechungsindex verfügen, entstehen an der Grenzschicht zwischen Kristall und Luft große Reflexionsverluste, welche die nutzbare Ausgangsleistung des Systems reduzieren. Um diese Verluste zu minimieren, werden erfindungsgemäß THz-Anti-Reflex-(AR)-Beschichtungen auf den Kristall aufgetragen werden. Diese Beschichtung kann beispielsweise aus einem Polymerfilm oder einer Oxidschicht bestehen, welche die für AR-Schichten übliche Dicke von einer viertel-Wellenlänge aufweist. Ebenfalls ist eine Strukturierung des Kristalls möglich: Werden in dem oberflächennahen Bereich Löcher in den Kristall eingebracht, welche viel kleiner sind als die Wellenlänge der THz-Strahlung, so bildet sich ein effektiver Brechungsindex dieser Region aus. Wird diese Schicht entsprechend auf die Wellenlänge angepasst, kann hierdurch eine Reflexionsminimierung erreicht werden.

Ein großer Brechzahlunterschied zwischen Kristall und Luft führt darüber hinaus zu einem Winkel der Totalreflexion, d.h. die THz-Strahlung, welche einen gewissen Einfallswinkel überschreitet, wird vollständig an der Grenzschicht reflektiert und geht somit verloren. Um auch schräg zu Oberfläche einstrahlende Wellenanteile nutzen zu können, kann eine erfindungsgemäße Auskoppelstruktur verwendet werden. In Fig. 18 ist dieses exemplarisch dargestellt.

Um die Totalreflektion, welche an der Grenzschicht zwischen dem Kristall und der Luft auftritt (Fig. 18a) zu vermeiden, kann eine Auskoppelstruktur verwendet werden (Fig. 18b).

Diese erfindungsgemäße Auskoppelstruktur kann beispielsweise aus einer Schräg geschnittenen Kristallkante, einer aufgesetzten, schräg geschnittenen Schicht, einem aufgesetzten Prima oder einer prismenartigen Oberflächenstrukturierung des Kristalls bestehen.

### THz-Linsen

Da die Quelle der THz-Strahlung ein kleines Generationsgebiet ist, weißt die emittierte Welle eine große Divergenz auf. Um die erzeugte Strahlung möglichst effektiv nutzen zu können, ist eine Kollimation der Welle über THz-Linsen erforderlich.

Hierbei ist ein auf die Wellenform optimiertes Linsendesign zu wählen. Wird die THz-Welle kollinear erzeugt, so weißt diese i.d.R. ein zirkulares Strahlenprofil auf, so dass sphärische oder asphärische Linsen für die Strahlformung geeignet sind.

Wird jedoch ein oberflächenemittierender Kristall verwendet, so verursacht das linienförmige Generationsgebiet ein elliptisches Strahlprofil: In eine Richtung tritt eine große Divergenz auf, in der anderen Richtung ist der Strahl bereits beinahe kollimiert. In diesem Fall ist eine THz-Linse zu verwenden, welche mit der Kreissymmetrie bricht. Beispielsweise kann eine Zylinderlinse als erstes Linsenobjekt verwendet werden.

Generell ist es möglich, eine Vorkollimation über eine Linsenstruktur, welche direkt auf dem Kristall aufgebracht wird, durchzuführen. Diese kann auch mit der AR-Beschichtung kombiniert werden. Die vorkollimierte Welle kann dann durch weitere Linsen vollständig kollimiert werden.

Um die Welle auf einen Detektor abzubilden, können wiederum THz-Linsen verwendet werden.

In jedem Fall stellen die folgende Linsen mögliche Komponenten für das System dar: sphärische Linsen, asphärische Linsen, Zylinderlinsen, asphärische Zylinderlinsen, Fresnel-Linsen und Grin-Linsen.

**Kristalle**

Für eine effiziente Konversion ist eine Phasenanpassung zwischen der erzeugten THz-Welle und den optischen Wellen zu erreichen. Dabei kann die Phasenanpassung sowohl für eine kollineare Wellenausbreitung oder für eine nichtkollineare Wellenausbreitung erfüllte sein. Dieses kann auf verschiedenen, erfindungsgemäßen Wegen erreicht werden, z.B.

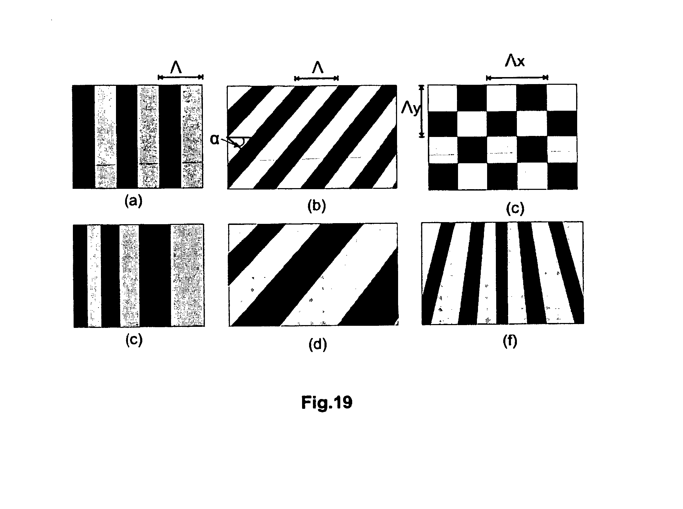

■ Über Quasi-Phasenanpassung: Die ferroelektrischen Kristalldomänen werden ein-, zwei- oder mehrdimensional gepolt. Die Polung ist periodisch, aperiodisch oder in andere Weise auf die verwendeten Frequenzen und Emissionsrichtung abzustimmen. Insbesondere kann eine geneigte/ungeneigte periodische Polung, eine geneigte/ungeneigte aperiodische Polung, eine schachbrettmusterförmige Polung, eine Fan-Out-Polung und eine Kombination aus diesen verwendet werden. In Fig. 19 sind Beispiele skizziert.

Einfache periodische Polung (Fig,. 19a), geneigte periodische Polung (Fig,. 19b), schachbrettmusterförmige Polung (Fig,. 19c), einfache aperiodische Polung (Fig,. 19d), geneigte aperiodische Polung (Fig,. 19e), Fan-Out-Polung (Fig,. 19f). Zur Verdeutlichung ist die Polungsperiode A (a)-(b), der Neigungswinkel der Polung a (b) und die zweidimensionalen Polungen $\Lambda_x$ und $\Lambda_y$ (c) eingezeichnet.

■ Über Doppelbrechung: Viele nichtlineare Kristalle weisen doppelbrechende Eigenschaften auf, d.h., der Brechungsindex hängt von der Polarisationsrichtung der elektromagnetischen Welle relativ zu den Kristallachsen ab. Hierbei wird zwischen ordentlichen und außerordentlichen Strahl unterschieden. Wird ein doppelbrechender Kristall unter einem gewissen Winkel geschnitten, so kann der effektive Brechungsindex des außerordentlichen Strahls als Funktion des Schnittwinkels verändert werden. Mit diesem Prinzip ist Phasenanpassung zu erreichen.

■ Es können nichtlineare Materialien gewählt werden, welche ohne weitere Modifikation die Phasenanpassung erfüllen.

■ Über Wellenleiterstrukturen: Das nichtlineare Medium kann in Form eines Wellenleiters ausgeführt werden. Durch diesen Wellenleiter kann eine Führung der optischen Wellen und/oder der THz-Welle erfolgen. Falls alle Wellen geführt werden, ist das Design so auszuführen, dass die effektiven Gruppengeschwindigkeiten aller Wellen angeglichen werden, d.h., dass die effektiven Brechungsindizes möglichst wenig voneinander abweichen. Um dieses auszuführen stehen sämtliche in Lehrbüchern beschriebene Wellenleiterkonfigurationen zur Verfügung (siehe z.B. Karl J. Ebeling, Integrierte Optoelektronik, Springer, Berlin, 1992.). Beispiele hierfür sind aufliegende Streifenwellenleiter, bündig versenkte Streifenwellenleiter, vollständig versenkte Streifenwellenleiter, Rippenwellenleiter, invertierte Rippenwellenleiter, Wellenleiter mit dielektrischem Laststreifen, Wellenleiter mit metallischen Laststreifen. Es gibt jedoch auch noch weitere Möglichkeiten, da das nichtlineare Material (oder die nichtlinearen Materialien) zur Realisierung eines Wellenleiters auch mit anderen Materialien kombiniert werden kann, die einen sehr kleinen oder einen verschwindenden nichtlinearen Koeffizienten, dafür aber einen für die Erreichung der Phasenanpassung zweckmäßigen Brechungsindex besitzen. Generell kann, um Phasenanpassung durch Wellenführung zu erreichen, ein strukturierter oder unstrukturierter nichtlinearer Kristall oder eine Kombination aus einem oder mehreren strukturierten oder unstrukturierten nichtlinearen Medien und anderen strukturierten oder unstrukturierten Materialen verwendet werden.

■ Es sind zudem auch Wellenleiter und/oder nichtlineare Materialien möglich, die photonische Kristallstrukturen beinhalten oder die auf sogenannten Metamaterialien mit negativem Brechungsindex beruhen.

Als Materialien bieten sich alle Stoffe an, welche einen nichtlinearen Koeffizienten aufweisen. Für optimale Konversionseffizienz sollte das Material über einen maximalen nichtlinearen Koeffizienten und eine minimale Absorption im THz-Bereich verfügen. Es sind auch Materialien geeignet, welche nichtlineare Mischung höhere Ordnung erlauben. Beispielsweise Vier-Wellen-Mischung oder Fünf-Wellen-Mischung.

Im Besonderen bieten sich folgende Materialien als nichtlineares Medium an. Dabei können diese entweder in reiner Form oder dotiert verwendet werden. Auch sind diese wahlweise mit einer QPM zu versehen, unter einen bestimmten Winkel zu schneiden oder als Wellenleiter zu strukturieren:

- Lithiumniobat (LiNbO3) in kongruenter und stöchiometrischer Form. Dieses Material kann besonders effizient mit einer QPM versehen werden. Insbesondere ist periodisch gepoltes Lithiumniobat (PPLN), geneigt periodisch gepoltes Lithiumniobat (TPPLN), aperiodisch gepoltes Lithiumniobat (APPLN), geneigt aperiodisch gepoltes Lithiumniobat (TAPPLN), schachbrettmusterförmig gepoltes Lithiumniobat und Lithiumniobat mit einer Fan-Out-Polung geeignet.

Eine andere Ausführungsform ist ein unstrukturierter Lithiumniobatkristall, der mit einer Auskoppelstruktur versehen ist, um THz-Abstrahlung unter dem Cherenkovwinkel zu nutzten.

Um den photorefraktiven Effekt zu vermindern, können diese Ausführungsformen mit anderen Stoffen dotiert werden. Beispielsweise mit Magnesiumoxid (MgO) oder Mangan (Mn).

- GaAs.
- Zink Germanium Diphosphid (ZGP, ZnGeP2), Silber Galliumsulfid und Selenid (AgGaS2 and AgGaSe2), und Cadmium Selenid (CdSe)
- ZnSe
- GaP
- GaSe
- Lithiumtantalat (LiTaO3)
- Lithiumtriborat
- Kaliumniobat (KNbO3)
- Kaliumtitanylphosphate (KTP, KTiOPO4)
- Alle Materialien aus der "KTP Familie" und ebenso KTA (KTiOAsO4), RTP (RbTiOPO4) und RTA (RbTiAsPO4), können ebenfalls periodisch gepolt werden
- Kaliumdihydrogenphosphat (KDP, KH2PO4) und Kaliumdideuterium phosphat (KD*P, KD2PO4)
- Beta Bariumborat (beta-BaB2O4 = BBO, BiB3O6 = BIBO, und Cesiumborat (CSB3O5 = CBO), Lithiumtriborat (LiB3O5 = LBO), Cesiumlithium Borat (CLBO, CsLiB6O10), Strontium Berylliumborat (Sr2Be2B2O7 = SBBO), Yttrium Kalziumoxyborat (YCOB) und K2Al2B2O7 = KAB
- Organische nichtlineare Medien. Insbesondere DAST.
- Nichtlinearer Medien auf Polymerbasis, beispielsweise elektro-optische Polymere. Insbesondere alle Verbindungen, die amorphe Polycarbonate oder Phenyltetraene enthalten.
- Silizium oder verspanntes Silizium
- Ferner alle Halbleitermaterialien in verspannter oder unverspannter Form, die über nichtverschwindende nichtlineare □- Koeffizienten verfügen.

Die Kristalle können so gestaltet werden, dass die THz-Abstrahlung kollinear oder nicht kollinear zu den optischen Wellen erfolgt. Hierbei können die Kristalle mit THz-Anti-Reflex- und/oder Auskoppelstrukturen versehen werden, um die erzeugten Wellen besser aus diesen zu extrahieren.

Der aktuelle Demonstrator wurde im cw-Betrieb untersucht, da der VECSEL kontinuierlich gepumpt wird und sich kein aktives oder passives Element im Resonator befindet mit dem eine gepulste Emission möglich wäre.

In einem weiteren Ausführungsbeispiel besteht die einfachste Möglichkeit die Vorrichtung dadurch gepulst zu betreiben, dass der Pumplaser gepulst wird, um letztendlich eine höhere intrakavitäre Leistung zu erhalten.

Eine weitere Möglichkeit, den VECSEL im Pulsmodus zu betreiben, besonders im Hinblick auf die Erzeugung deutlich kürzerer Pulse und somit signifikant höherer Intensitäten, ist der Einsatz von aktiven Elementen: In den Resonator kann ein aktives Element, z.B. ein Güteschalter eingebaut werden, um Pulse im Nanosekunden bzw. Pikosekunden Bereich zu erzeugen.

Um zu noch kürzeren Pulsen im Femtosekunden Bereich zu kommen, kann alternativ zur Erfindung z.B. ein sättigbarer Absorber als passives Element in den Resonator integriert werden. Diese ultrakurzen Pulse werden durch die sog. Modenkopplung erreicht.

Literatur :

[1] Chilla J. et al., Recent advances in optically pumped semiconductor lasers , Proc. SPIE 6451 645109 (2007)

[2] Yushi Kaneda, Li Fan, Ta-Chen Hsu, Nasser Peyghambarian, Mahmoud Fallahi, Aramais R.Zakharian, Jorg Hader, Jerome V.Moloney, Wolfgang Stolz, Stephan W. Koch, Robert Bedford, Armen Sevian and Leonid Glebov, "High Brightness Spectral Beam Combination of High Power Vertical External Cavity Surface Emitting Lasers," IEEE Photonics Technology Letters, 18. 1795 (2006).

[3] Li Fan, Ta-Chen Hsu, Mahmoud Fallahi, James T. Murray, Robert Bedford, Yushi Kaneda, Aramais R.Zakharian, Jorg Hader, Jerome V.Moloney, Wolfgang Stolz, and Stephan W. Koch, "Tunable watt-level blue-green vertical-external-cavity surface-emitting lasers by intracavity frequency doubling," Applied Physics Letters, 88, 251117 (2006) (This paper was highlighted by Photonics Spectra).

[4] Li Fan, Mahmoud Fallahi, James T. Murray, Robert Bedford, Yushi Kaneda, Aramais R. Zakharian, Jorg Hader, Jerome V.Moloney, Wolfgang Stolz, and Stephan W. Koch, "Tunable high-power high-brightness linearly polarized vertical-external-cavity surface-emitting lasers," Applied Physics Letters 88, pp.021105 (2006) (This paper was highlighted by Photonics Spectra (March 2006, p24).

[5] Li Fan, Mahmoud Fallahi, Jorg Hader , Aramais R Zakharian, Jerome V. Moloney, Wolfgang Stolz, Stephan W. Koch. Robert Bedford, James T. Murray, "Linearly polarized dual-wavelength vertical-external-cavity surface-emitting laser", Applied Physics Letters 90 (18), 181124, Apr 30 2007.

[6] Li Fan, Mahmoud Fallahi, Aramais R. Zakharian, Jorg Hader, Jerome Moloney, Robert Bedford, James T. Murray, Wolfgang Stolz, and Stephan W. Koch, "Enhanced tunability of a two-chip vertical-external-cavity surface emitting laser", IEEE Photonics Technology Letters, Vol. 19, No. 8, pp 544-546, 2007.

[7] Li Fan, Mahmoud Fallahi, Jorg Hader , Aramais R Zakharian, Jerome V. Moloney, Wolfgang Stolz, Stephan W. Koch, Robert Bedford, James T. Murray, "Linearly polarized dual-wavelength vertical-external-cavity surface-emitting laser", Applied Physics Letters 90 (18), 181124, Apr 30 2007.

[8] J.V. Moloney, J. Hader, and S.W. Koch, "Laser and amplifier applications", Laser & Photon. Rev. Vol. 1, pp. 24-43 (2007).

[9] U. Brauch, A. Giesen, M. Karszewski, C. Stewen, and A. Voss, "Multiwatt diodepumped Yb:YAG thin disk laser continuously tunable between 1018 and 1053 nm," Opt Lett. 20, 713- (1995)

[10] Mooradian et al.: HIGH POWER EXTENDED VERTICAL CAVITY SURFACE EMITTING DIODE LASERS AND ARRAYS AND THEIR APPLICATIONS, Micro-Optics Conference, Tokyo, November 2, 2005

[11] J.A. L'Huillier et al.: Generation of THz radiation using bulk, periodically and periodically poled lithium niobate - Part 1: Theory, Appl. Phys. B 86, 185-196 (2007)

[12] A. Ashkin, G. D. Boyd, J. M. Dziedzic, R. G. Smith, A. A. Ballman, J. J. Levinstein, K. Nassau, Optically-induced refractive index inhomogeneities in LiNbO3 and LiTaO3, Appl. Phys. Lett. 9, 1 (1966)

[13] Peter F. Bordui, and Martin M. Fejer, Inorganic Crystals for Nonlinear Optical Frequency Conversion, Annual Review of Materials Science Vol. 23: 321-37 (1993)

[14] D. A. Bryan, Robert Gerson, and H. E. Tomaschke, Increased optical damage resistance in lithium niobate, Appl. Phys. Lett. 44, 847 (1984)

[15] S. Verghese, K. A. McIntosh, S. Calawa, W. F. Dinatale, E. K. Duerr und K. A. Molvar, "Generation and detection of coherent terahertz waves using two photomixers", Appl. Phys. Lett. 73, 3824 (1998).

[16] Nahata et al.: Free-space electro-optic detection of continuous-wave terahertz radiation, APPLIED PHYSICS LETTERS VOLUME 75, NUMBER 17 (1999)

[17] U. Keller et al.: Passively modelocked surface-emitting semiconductor lasers, Physics Reports 429 (2006) 67 - 120.

**Patentansprüche**

1. Verfahren zur Erzeugung elektromagnetischer Strahlung im Terahertz- und Millimeterbereich mit folgenden Verfahrensschritten:

   a) Bereitstellen eines oberflächenemittierenden Halbleiterlasers mit vertikalem externem Resonator, der einen Halbleiterkörper, der einen Braggspiegel sowie eine Schichtenfolge von Halbleiterquantenfilmen als Lasermaterial aufweist, und einen Laserresonator aufweist, wobei der Braggspiegel einen Spiegel des Laserresonators bildet während sich alle weiteren Spiegel des Laserresonators außerhalb des Halbleiterkörpers befinden;
   b) Positionierung eines wellenlängenselektiven Filters innerhalb des Laserresonators;
   c) Dauerstrichbetrieb des Lasers im Zweifarbenmodus, wobei das Emissionsspektrum durch den wellenlängenselektiven Filter derartig beschränkt wird, dass Laserstrahlung mit zwei spektral voneinander beabstandeten Frequenzen erzeugt wird;
   d) Positionierung eines nichtlinearen Mediums innerhalb des Laserresonators derart, dass über Differenzfrequenzerzeugung aus den zwei spektral voneinander beabstandeten Frequenzen Strahlung im Terahertz- und Millimeterbereich generiert wird.

2. Verfahren nach Anspruch 1, **dadurch gekennzeichnet, dass** das nichtlineare Medium ein Halbleiter oder Lithiumniobat ist.

3. Verfahren nach Anspruch 1 oder 2, **dadurch gekennzeichnet, dass** das nichtlineare Medium periodisch gepoltes Lithiumniobat ist.

4. Verfahren nach einem der Ansprüche 1 bis 3, **dadurch gekennzeichnet, dass** das nichtlineare Medium in einer Wellenleitergeometrie für THz-Wellen geformt ist.

5. Verfahren nach einem der Ansprüche 1 bis 4, **dadurch gekennzeichnet, dass** die in dem nichtlinearen Medium vorhandene optische Leistungsdichte maximiert wird, indem nur hochreflektierende Spiegel als Teil des Laserresonators verwendet werden.

6. Verfahren nach einem der Ansprüche 1 bis 5, **dadurch gekennzeichnet, dass** die THz-Strahlung nicht kollinear zu den optischen Wellen im nichtlinearen Medium erzeugt und direkt aus dem Laserresonator ausgekoppelt wird.

7. Vorrichtung zur Erzeugung von elektromagnetischer Strahlung im Terahertz- und Millimeterbereich, mit:

   a) Einem oberflächenemittierenden Halbleiterlaser mit vertikalem externen Resonator, im folgenden kurz VECSEL, der einen Halbleiterkörper mit einem Braggspiegel und einer Schichtenfolge von Halbleiterquantenfilmen als aktivem Lasermaterial und einen Laserresonator aufweist, wobei der Braggspiegel einen Spiegel des Resonators bildet, während sich alle weiteren Spiegel außerhalb des Halbleiterkörpers befinden;
   b) Einem wellenlängenselektiven Filter innerhalb des Laserresonators, der das Emissionsspektrum derart beschränkt, dass der Laser im Dauerstrichbetrieb und im Zweifarbenmodus, bei dem Laserstrahlung mit spektral voneinander beabstandeten Frequenzen erzeugt wird, betreibbar ist;
   c) Einem nichtlinearen Medium innerhalb des Laserresonators derart, dass über Differenzfrequenzerzeugung aus den zwei spektral voneinander beabstandeten Frequenzen Strahlung im Terahertz- und Millimeterbereich generierbar ist; und
   d) Mitteln zur Extraktion der Strahlung im Terahertz- und Millimeterbereich aus dem Laserresonator, wobei das nichtlineare Medium und die Mittel zur Extraktion gemeinsam in Form eines nichtlinearen Kristalls ausgebildet sind.

8. Vorrichtung nach Anspruch 7, **dadurch gekennzeichnet, dass** die Vorrichtung Mittel zum optischen oder elektrischen Pumpen des VECSEL aufweist.

9. Vorrichtung nach Anspruch 7 oder 8, **dadurch gekennzeichnet, dass** der nichtlineare Kristall eine Auskopplungsstruktur zur Vermeidung von Reflexionsverlusten an der Grenzschicht zwischen Kristall und Luft aufweist, wobei diese Auskoppelstruktur beispielsweise aus einer schräg geschnittenen Kristallkante, einer aufgesetzten, schräg geschnittenen Schicht, einem aufgesetzten Prisma oder einer prismenartigen Oberflächenstrukturierung des Kristalls besteht.

**Claims**

1. Method for generating electromagnetic radiation in the terahertz and millimetre range, comprising the following method steps:

   a) providing a vertical-external-cavity surface-emitting semiconductor laser having a semiconductor body, which has a distributed Bragg reflector and a series of layers of semiconductor quantum films as the laser material, and a laser resonator, wherein the distributed Bragg reflector forms a laser resonator mirror while all the other laser resonator mirrors are outside the semiconductor body;
   b) positioning a wavelength-selective filter within the laser resonator;
   c) operating the laser in continuous-wave operation in dichroic mode, wherein the emission spectrum is limited by the wavelength-selective filter in such a way as to generate laser radiation with two spectrally-spaced frequencies;
   d) positioning a non-linear medium within the laser resonator in such a way as to generate radiation in the terahertz and millimetre range from the two spectrally spaced frequencies by difference frequency generation.

2. Method according to claim 1, **characterised in that** the non-linear medium is a semiconductor or lithium niobate.

3. Method according to either claim 1 or claim 2, **characterised in that** the non-linear medium is periodically polarised lithium niobate.

4. Method according to any of claims 1 to 3, **characterised in that** the non-linear medium is formed in a waveguide geometry for THz waves.

5. Method according to any of claims 1 to 4, **characterised in that** the optical energy density in the non-linear medium is maximised by only using highly reflective mirrors as part of the laser resonator.

6. Method according to any of claims 1 to 5, **characterised in that** the THz radiation is generated in the non-linear medium so as not to be collinear with the optical waves, and is decoupled directly out of the laser resonator.

7. Device for generating electromagnetic radiation in the terahertz and millimetre range, comprising:

   a) a vertical-external-cavity surface-emitting semiconductor laser (VECSEL) having a semiconductor body, which has a distributed Bragg reflector and a series of layers of semiconductor quantum films as the active laser material, and a laser resonator, wherein the distributed Bragg reflector forms a resonator mirror, while all the other mirrors are located outside the semiconductor body;
   b) a wavelength-selective filter within the laser resonator which limits the emission spectrum such that the laser can be operated in continuous wave operation in dichroic mode, in which laser radiation is generated at two spectrally-spaced frequencies;
   c) a non-linear medium within the laser resonator such that radiation in the terahertz and millimetre range can be generated from the two spectrally-spaced frequencies by difference frequency generation; and
   d) means for extracting the radiation in the terahertz and millimetre range from the laser resonator, wherein the non-linear medium and the extraction means are jointly in the form of a non-linear crystal.

8. Device according to claim 7, **characterised in that** the device has means for optically or electrically pumping the VECSEL.

9. Device according to either claim 7 or claim 8, **characterised in that** the non-linear crystal has a decoupling structure for preventing reflection losses at the boundary layer between crystal and air, said decoupling structure for example consisting of an obliquely cut crystal edge, an obliquely cut layer placed thereon, a prism placed thereon, or a prism-like surface structure of the crystal.

**Revendications**

1. Procédé de production d'un rayonnement électromagnétique dans les plages d'ondes térahertziennes et millimétriques, comprenant les étapes consistant à :

a) préparer un laser à semi-conducteurs émettant en surface avec un résonateur externe vertical, qui présente un corps à semi-conducteurs, qui présente lui-même un miroir de Bragg ainsi qu'une suite de couches de films quantiques semi-conducteurs comme matériau laser, et un résonateur laser, dans lequel le miroir de Bragg forme un miroir du résonateur laser, tandis que tous les autres miroirs du résonateur laser se trouvent en dehors du corps à semi-conducteurs ;

(b) positionner un filtre sélectif en longueurs d'ondes à l'intérieur du résonateur laser ;

(c) faire fonctionner le laser en ondes entretenues en mode à deux couleurs, dans lequel le spectre d'émission est limité par le filtre sélectif en longueurs d'ondes de sorte que le rayonnement laser soit produit avec deux fréquences spectralement distantes l'une de l'autre ; et

(d) positionner un support non linéaire dans le résonateur laser de sorte que soit généré un rayonnement dans les plages d'ondes térahertziennes et millimétriques via la production de fréquences de différences à partir des deux fréquences spectralement distantes l'une de l'autre.

2. Procédé selon la revendication 1, **caractérisé en ce que** le support non linéaire est un semi-conducteur ou du niobate de lithium.

3. Procédé selon la revendication 1 ou la revendication 2, **caractérisé en ce que** le support non linéaire est du niobate de lithium périodiquement polarisé.

4. Procédé selon l'une quelconque des revendications 1 à 3, **caractérisé en ce que** le support non linéaire est formé selon une géométrie de guide d'ondes pour ondes térahertziennes.

5. Procédé selon l'une quelconque des revendications 1 à 4, **caractérisé en ce que** la puissance volumique optique présente dans le support non linéaire est maximisée en utilisant uniquement des miroirs hautement réfléchissants comme partie du résonateur laser.

6. Procédé selon l'une quelconque des revendications 1 à 5, **caractérisé en ce que** le rayonnement térahertzien est produit dans le support non linéaire de façon non colinéaire avec les ondes optiques et est déclenché directement du résonateur laser.

7. Appareil de production d'un rayonnement électromagnétique dans les plages d'ondes térahertziennes et millimétriques, comprenant :

a) un laser à semi-conducteurs émettant en surface avec un résonateur externe vertical, dénommé par la suite en abrégé VECSEL, qui présente un corps à semi-conducteurs avec un miroir de Bragg et une suite de couches de films quantiques semi-conducteurs comme matériau laser actif et un résonateur laser, dans lequel le miroir de Bragg forme un miroir du résonateur, tandis que tous les autres miroirs se trouvent en dehors du corps à semi-conducteurs ;

(b) un filtre sélectif en longueurs d'ondes à l'intérieur du résonateur laser, qui limite le spectre d'émission de sorte que le laser puisse opérer en ondes entretenues et en mode à deux couleurs, dans lequel le rayonnement laser est produit avec des fréquences spectralement distantes l'une de l'autre ;

(c) un support non linéaire dans le résonateur laser de sorte que puisse être généré un rayonnement dans les plages d'ondes térahertziennes et millimétriques via la production de fréquences de différences à partir des deux fréquences spectralement distantes l'une de l'autre ; et

(d) des moyens d'extraction du rayonnement dans les plages d'ondes térahertziennes et millimétriques à partir du résonateur laser, dans lequel le support non linéaire et les moyens d'extraction se présentent conjointement sous la forme d'un cristal non linéaire.

8. Appareil selon la revendication 7, **caractérisé en ce que** l'appareil présente des moyens pour le pompage optique ou électrique du VECSEL.

9. Appareil selon la revendication 7 ou la revendication 8, **caractérisé en ce que** le cristal non linéaire présente une structure de déclenchement pour éviter des pertes par réflexion sur la couche limite entre le cristal et l'air, dans lequel cette structure de déclenchement est constituée par exemple d'une arête de cristal à section oblique, d'une couche rapportée à section oblique, d'un prisme rapporté ou d'une conformation superficielle de type prismatique du cristal.

Frequenz (Hz)

Fig. 1

Fig. 2

**THz-Lücke**

Electronic

IMPATT

Optical

Neue Quelle

QC Laser

III-V's

TUNNETT

SLED

Gunn

RTD

← HG

Lead salts

RTD array

After J. Allen, UCSB

CW output power [Watt]

Frequency [THz]

Fig. 3

Modenprofil der Laser-Strahlung

Modenprofil der THz-Strahlung

Luftspalt, oder Material mit einem Brechungsindex, der klein gegenüber sämtlichen anderen Brechungsindizes der anderen Materialien ist.

Material mit einem hohem Brechungsindex $n_{Nachbar}$ für die THz-Strahlung, so das $n_{Nachbar} > n_{Las}$

Material, in dem der Brechungsindex für die Laserstrahlung $n_{Las}$ größer ist als der Brechungsindex für die THz-Strahlung $n_{THz}$

Fig. 4

**Fig. 5**

**Fig. 6**

VECSEL Spektrum für verschiedene Etalon Winkel,
Winkel 1 < Winkel 2

Fig. 7

Fig. 8

26

THz-Ausgangsleistung bei f=675 GHz

**Fig. 9**

**Fig. 10**

**Fig. 11a**

**Fig. 11b**

Etalon

Brewster Fenster

Hochreflektierender
Spiegel

Nichtlinearer Kristall

Linse

Auskoppelspiegel

2-Farben Laser

Pumplaser

Wärmesenke

THz Strahlung

THz-Optik

**Fig. 12**

Brewster Fenster

hochreflektierender
Spiegel

Nichtlinearer Kristall

Pumplaser

Wärmesenke

Auskoppelspiegel

THz Strahlung

THz-Optik

externer Laser

**Fig. 13**

**Fig. 14**

**Fig. 15**

**Fig. 16a**

**Fig. 16b**

Fig. 17

Fig. 18

(a)  (b)  (c)

(c)  (d)  (f)

**Fig.19**

**EP 2 263 290 B1**

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- US 5802086 A
- US 2008043320 A1

- US 61067949 B

**In der Beschreibung aufgeführte Nicht-Patentliteratur**

- **FAN LI et al.** Linearly polarized dual-wavelength vertical-external-cavity surface emittinglaser. *APPLIED PHYSICS LETTERS,* 03. Mai 2007, vol. 90 (18), 181124-181124
- **KARL J. EBELING.** Integrierte Optoelektronik. Springer, 1992
- **A. ASHKIN ; G. D. BOYD ; J. M. DZIEDUC ; R. G. SMITH ; A. A. BALLMANAND ; J. LEVINSTEIN ; K. NASSAU.** Optically-induced refractive index inhomogeneities in LiNbO3 and LiTaO. *Appl. Phys. Lett.,* 1966, vol. 9
- **L. MICHAEL HAYDEN ; A. M. SINYUKOV ; M. R. LEAHY ; P. LINDAHL ; J. FRENCH ; W. HERMAN ; M. HE ; R. TWIEG.** New materials for optical rectification and electro-optic sampling of ultra-short pulses in the thz regime. *J. Polymer Sci. B. Polymer Phys,* 2003, vol. 41, 2492-2500
- **A. M. SINYUKOV ; L. MICHAEL HAYDEN.** Efficient electro-optic polymers for thz applications. *J. Phys. Chem. B,* 2004, vol. 108, 8515-8522
- **XUEMEI ZHENG ; ALEXANDER SINYUKOV ; L. MICHAEL HAYDEN.** Broadband and gap-free response of a terahertz system based on a poled polymer emitter-sensor pair. *Applied Physics Letters,* 2005, vol. 87 (8), 081115
- **RUNE S. JACOBSEN ; KARIN N. ANDERSEN ; PETER I. BOREL ; JACOB FAGE-PEDERSEN ; LARS H. FRANDSEN ; OLE HANSEN ; MARTIN KRISTENSEN ; ANDREI V. LAVRINENKO ; GAID MOULIN ; HAIYAN OU.** Strained silicon as a new electro-optic material. *Nature,* 2006, vol. 441, 199-202
- **CHILLA J. et al.** Recent advances in optically pumped semiconductor lasers. *Proc. SPIE 6451,* 2007, 645109
- **YUSHI KANEDA ; LI FAN ; TA-CHEN HSU ; NASSER PEYGHAMBARIAN ; MAHMOUD FALLAHI ; ARAMAIS R.ZAKHARIAN ; JORG HADER ; JEROME V.MOLONEY ; WOLFGANG STOLZ ; STEPHAN W. KOCH.** High Brightness Spectral Beam Combination of High Power Vertical External Cavity Surface Emitting Lasers. *IEEE Photonics Technology Letters,* 2006, vol. 18, 1795

- **LI FAN ; TA-CHEN HSU ; MAHMOUD FALLAHI ; JAMES T. MURRAY ; ROBERT BEDFORD ; YUSHI KANEDA ; ARAMAIS R.ZAKHARIAN ; JORG HADER ; JEROME V.MOLONEY ; WOLFGANG STOLZ.** Tunable watt-level blue-green vertical-external-cavity surface-emitting lasers by intracavity frequency doubling. *Applied Physics Letters,* 2006, vol. 88, 251117
- **LI FAN ; MAHMOUD FALLAHI ; JAMES T. MURRAY ; ROBERT BEDFORD ; YUSHI KANEDA ; ARAMAIS R. ZAKHARIAN ; JORG HADER ; JEROME V.MOLONEY ; WOLFGANG STOLZ ; STEPHAN W. KOCH.** Tunable high-power high-brightness linearly polarized vertical-external-cavity surface-emitting lasers. *Applied Physics Letters,* 2006, vol. 88, 021105
- *Photonics Spectra,* Marz 2006, 24
- **LI FAN ; MAHMOUD FALLAHI ; JORG HADER ; ARAMAIS R ZAKHARIAN ; JEROME V. MOLONEY ; WOLFGANG STOLZ ; STEPHAN W. KOCH ; ROBERT BEDFORD ; JAMES T. MURRAY.** Linearly polarized dual-wavelength vertical-external-cavity surface-emitting laser. *Applied Physics Letters,* 30. April 2007, vol. 90 (18), 181124
- **LI FAN ; MAHMOUD FALLAHI ; ARAMAIS R. ZAKHARIAN ; JORG HADER ; JEROME MOLONEY ; ROBERT BEDFORD ; JAMES T. MURRAY ; WOLFGANG STOLZ ; STEPHAN W. KOCH.** Enhanced tunability of a two-chip vertical-external-cavity surface emitting laser. *IEEE Photonics Technology Letters,* 2007, vol. 19 (8), 544-546
- **J.V. MOLONEY ; J. HADER ; S.W. KOCH.** Laser and amplifier applications. *Laser & Photon. Rev.,* 2007, vol. 1, 24-43
- **U. BRAUCH ; A. GIESEN ; M. KARSZEWSKI ; C. STEWEN ; A. VOSS.** Multiwatt diodepumped Yb:YAG thin disk laser continuously tunable between 1018 and 1053 nm. *Opt Lett.,* 1995, vol. 20, 713

- **MOORADIAN et al.** HIGH POWER EXTENDED VERTICAL CAVITY SURFACE EMITTING DIODE LASERS AND ARRAYS AND THEIR APPLICATIONS. *Micro-Optics Conference, Tokyo,* 02. November 2005
- **J.A. L'HUILLIER et al.** Generation of THz radiation using bulk, periodically and periodically poled lithi um niobate - Part 1: Theory. *Appl. Phys. B,* 2007, vol. 86, 185-196
- **A. ASHKIN ; G. D. BOYD ; J. M. DZIEDZIC ; R. G. SMITH ; A. A. BALLMAN ; J. J. LEVINSTEIN ; K. NASSAU.** Optically-induced refractive index inhomogeneities in LiNbO3 and LiTaO. *Appl. Phys. Lett.,* 1966, vol. 9, 1
- **PETER F. BORDUI ; MARTIN M. FEJER.** Inorganic Crystals for Nonlinear Optical Frequency Conversion. *Annual Review of Materials Science,* 1993, vol. 23, 321-37
- **D. A. BRYAN ; ROBERT GERSON ; H. E. TOMAS-CHKE.** Increased optical damage resistance in lithium niobate. *Appl. Phys. Lett.,* 1984, vol. 44, 847
- **S. VERGHESE ; K. A. MCINTOSH ; S. CALAWA ; W. F. DINATALE ; E. K. DUERR ; K. A. MOLVAR.** Generation and detection of coherent terahertz waves using two photomixers. *Appl. Phys. Lett.,* 1998, vol. 73, 3824
- **NAHATA et al.** Free-space electro-optic detection of continuous-wave terahertz radiation. *APPLIED PHYSICS LETTERS,* 1999, vol. 75 (17
- **U. KELLER et al.** Passively modelocked surface-emitting semiconductor lasers. *Physics Reports,* 2006, vol. 429, 67-120